# EUROPÄISCHE PATENTANMELDUNG

(11) **EP 0 849 814 A2**
(43) Veröffentlichungstag der Anmeldung: **24.06.1998**
(21) Anmeldenummer: 97890253.4
(22) Anmeldetag: 18.12.1997
(51) Int. Cl.: H01L 51/30, H05B 33/14, H05B 33/10

(54) **Elektrolumineszenzvorrichtung**

(30) Priorität: 18.12.1996 US 768497
(71) Anmelder: Leising, Günther, Prof. Dipl.-Ing Dr., 8042 Graz (AT)
(72) Erfinder: Leising, Günther, Dr., 8042 Graz (AT); Hampel, Stefan, 8742 Obdach (AT); Meghdadi, Farideh, Dipl.-Ing., 8010 Graz (AT); Winkler, Berthold, Dipl.-Ing., 8010 Graz (AT); Brandstätter, Christoph, Dipl.-Ing., 8010 Graz (AT); Scherf, Ullrich, Dr., 55252 Mainz-Kastel (DE); Tasch, Stefan, Dipl.-Ing., 8380 Jennersdorf (AT)
(74) Vertreter: Gibler, Ferdinand

(57) **Zusammenfassung**

Elektrolumineszenzvorrichtung bestehend aus einem Mehrschichtsystem, welches eine unter Einwirkung eines elektrischen Feldes Licht erzeugende aktive Elektrolumineszenzschicht aus einem organischen Halbleiter umfaßt, die zwischen einer Elektronen in die Elektrolumineszenzschicht injizierenden Kathodenschicht und einer Löcher in die Elektrolumineszenzschicht injizierenden Anodenschicht angeordnet ist, wobei gegebenenfalls zwischen der Anodenschicht und der Elektrolumineszenzschicht eine Löcherinjektionsschicht und/oder zwischen der Kathodenschicht und der Elektrolumineszenzschicht eine Elektroneninjektionsschicht angeordnet ist, wobei die Elektrolumineszenzschicht (3) langkettiges Oligophenylen in Form einer Verbindung der Formel 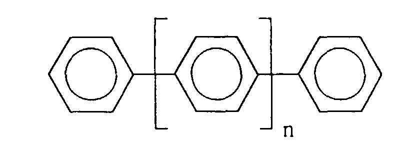 wobei n=2-20, umfaßt.

## Beschreibung

Die Erfindung betrifft eine Elektrolumineszenzvorrichtung bestehend aus einem Mehrschichtsystem, welches eine unter Einwirkung eines elektrischen Feldes Licht erzeugende aktive Elektrolumineszenzschicht aus einem organischen Halbleiter umfaßt, die zwischen einer Elektronen in die Elektrolumineszenzschicht injizierenden Kathodenschicht und einer Löcher in die aktive Schicht injizierenden Anodenschicht angeordnet ist, wobei gegebenenfalls zwischen der Anodenschicht und der Elektrolumineszenzschicht eine Löcherinjektionsschicht und/oder zwischen der Kathodenschicht und der Elektrolumineszenzschicht eine Elektroneninjektionsschicht angeordnet ist.

Bekannte Vorrichtungen dieser Art emittieren in einem Spektralbereich Licht, welcher vorzugsweise das höherenergetische Ende des sichtbaren Bereiches darstellt und somit im wesentlichen durch die sichtbare Farbe Blau oder durch das unsichtbare Ultraviolett erkennbar ist. Der bedeutende Vorteil von Licht dieses Spektralbereiches liegt darin, daß dieses auf einfache Weise in jede andere Farbe des sichtbaren Bereiches umgewandelt werden kann. So kann beispielsweise ein fluoreszierender Farbstoff angeregt werden, der dann durch Photolumineszenz in einem niedrigeren Energiebereich Licht mit längerer Wellenlänge aussendet.

Die Erzeugung des Lichtes in der aktiven Elektrolumineszenzschicht erfolgt durch organische Halbleiter, wobei die Elektronen und Löcher von gegenüberliegenden Elektroden in diesen organischen Halbleiter injiziert werden, wenn eine externe Spannung, üblicherweise zwischen 5 und 20V angelegt wird. Die Elektrolumineszenz tritt auf, wenn die Vereinigung der entgegengesetzt geladenen Ladungsträger zur Bildung von Excitonenzuständen (Singlet-Excitonen) führt, die dann strahlend abklingen. Organische Elektrolumineszenzvorrichtungen können mikrometerdünn, biegsam und großflächig gebaut werden, welche Farben vom Nah- Infrarot bis zum Ultraviolett-Spektralbereich aussenden. Die Anwendung von organischen Halbleitern in Farbflachbildschirmen ist aufgrund der hohen erreichbaren Lichtstärke (> 10000 cd/m²), des hohen Wirkungsgrades und der niedrigen Betriebsspannungen sehr vielversprechend. Organische Dünnfilm-Elektrolumineszenzvorrichtungen haben aufgrund ihrer einfachen Produktionsweise, der hohen erreichbaren Helligkeit und der Vielfalt von zur Verfügung stehenden Emissionsfarben vielseitige Anwendungen in Mehrfarben- Flachbildschirmen gefunden.

Die erste wissenschaftliche Publikation auf dem Gebiet der Polymer-Halbleiterdioden von J.H. Burroughes wurde in Nature 347 (1990) veröffentlicht und betrifft die Verwendung von Polyphenylenvinylen (PPV) als aktive Elektrolumineszenzschicht.

Die Emission von sichtbarem Licht in organischen Halbleitern ist unter anderem auch durch den Artikel in Appl.Phys.Lett.51,(1987) bekanntgeworden, wobei die Elektrolumineszenz von konjugierten Polymeren wie MEH-PPV dazu verwendet wird, eine lichtemittierende Leuchtdiode (LED) zu schaffen, die einen gleichrichtenden Metallkontakt auf der Oberfläche eines auf einem mit Indium-Zinnoxid (ITO) beschichteten Glassubstrat aufgetragenen MEH-PPV-Filmes aufweist. Zur Erklärung des Leuchtphänomens wird in diesem Artikel ein Tunnelmodell bevorzugt, in welchem die Elektronen vom gleichrichtenden Metallkontakt direkt in ein oberes Polaronen-Niveau gelangen.

Im Artikel Adv.Mat. 4 (1992), 36-37 wird auf die Problematik der Erzeugung von blauem Licht mit LED eingegangen und eine blaues Licht aussendende PPP-LED vorgeschlagen, die die üblichen ITO-Glassubstrat- und Aluminium-Elektroden beinhalten.

Die erstmalige Anwendung von leiterartigem Poly(paraphenylen) LPPP mit teilweise protonierten Seitengruppen in Elektrolumineszenzvorrichtungen wurde durch G. Grem und G. Leising in Sythetic Metals 1993 berichtet.

Aus der DE-A1-38 04 293 ist eine Anordnung mit einer Elektrolumineszenzdiode bekanntgeworden, in der die lichtabstrahlende Oberfläche der Diode mit einem Element aus einem Kunststoff bedeckt ist, der einen Zusatz an Titanoxid und an mindestens einem fluoreszierden, lichtwandelnden organischen Farbstoff wie Polymethylmethacrylat enthält.

Weiters ist in der JP-A-4 276 171 (Abstracts of Japan Vol 18., Nr. 419) ein organisches Elektrolumineszenz-Element mit starker Leuchtemission geoffenbart, die durch das Verwenden eines transparenten Substrates, von transparenten Elektroden und eines Farbfilters aus BPF erreicht wird. Der Einsatz eines Filters bewirkt eine deutliche Verschmälerung des Emissionsspektrums.

In der US-PS-5 408 109 sind aus löslichen halbleitenden Polymeren wie etwa MEH-PPV gefertigte LED beschrieben, die keine Wärmebehandlung zur Polymerisierung erfordern.

Weiters sind in der US-PS-4 885 211 ebenfalls verschiedene organische Lumineszenzmedien diskutiert, wobei eine besonders vorteilhafte Zusammensetzung einer LED-Anordnung hervorgehoben wird, in der zwischen zwei Elektroden, von der eine eine hohe und die andere eine niedrige Austrittsarbeit aufweisen, eine Löchertransport- und eine Elektronentransportschicht angeordnet sind. Die Kathode umfaßt dabei eine Schicht aus mehreren Metallen, von denen zumindest eine eine hohe Austrittsarbeit aufweist.

Auch die in der US-PS-4 539 507 erläuterte Elektrolumineszenz-Zelle umfaßt eine Löcherinjektionsschicht und eine Elektronentransportschicht, wobei die erstere an eine transparente metallische Anode angrenzt, aus der die Löcher injiziert werden.

Die Realisierung von Farbbildpunkten (pixels), aus denen ein Flachbildschirm zusammengesetzt wird, kann etwa durch nebeneinander angeordnete blaue, grüne und rote organische lichtemittierende Dioden (OLED) geschehen oder durch solche die in Abhängigkeit von der angelegten Spannung, vom durchfließenden Strom, von der Umgebungstemperatur oder anderen Parametern einstellbare Lichtwellenlängen erzeugen.

Aus dem Tagungsbericht "IS&T 49th Annual Conference" geht eine organische Elektrolumineszenzvorrichtung hervor, in der eine blaue organische Elektrolumineszenzanzeige mit farbändernden Medien kombiniert wird. Die farbändernden Medien sind im wesentlichen aus einem organischen fluoreszierenden Farbstoff, der die ausgestrahlte Farbe von Blau auf Grün oder Rot ändert, gebildet. Die blaue organische Mehrschicht-Elektrolumineszenzvorrichtung besteht aus einer ITO-Anode, einer Löcherinjektionsschicht, einer Löchertransportschicht, einer Emissionsschicht (DPVBI), einer Elektronentransportschicht und einer Kathode aus Magnesium und Aluminium. Zur Erzielung der Mehrfärbigkeit werden auf einer Glasschicht in einem Muster nebeneinander rote, grüne und blaue Unterpixels angeordnet, wobei die rote und die grüne Farbe jeweils durch eine rote bzw. grüne Farbstoffschicht auf der blauen Emissionsschicht erzeugt werden. Darauf ist eine Schutzschicht aufgetragen, auf die die Anode und alle anderen Schichten inklusive blauer Emissionsschicht und Kathode, folgen. Der Nachteil dieser Vorrichtung besteht darin, daß die rote Farbe aufgrund des geringen Spektralanteils dieser Farbe an der blauen von der aktiven Schicht ausgesendeten Farbe nur sehr schwache Intensität aufweist.

Die US-PS-5 126 214 offenbart eine Elektrolumineszenzvorrichtung, bei der über fluoreszierende Farbschichten eine Umwandlung des blauen Lichtes in rotes und grünes Licht erfolgt. Die Erzeugung des Rotlichtes aus der blauen Grundstrahlung wird durch die Überlagerung zweier verschiedener Farbstoffschichten vorgenommen. Zur Verbesserung der Effizienz der Strahlungerzeugung sind dabei sowohl Elektronentransportschichten als auch Löchertransportschichten vorgesehen.

Ebenso beschreibt die US-PS-5 294 870 eine in blauer Farbe emittierende Elektrolumineszenzvorrichtung, die in der Bildpunktmatrix eines Bildschirmes strukturiert ist. Die Grundstrahlung Blau wird über fluoreszierende Farbschichten in die anderen Grundfarben Grün und Rot gewandelt, wobei jeder Farbbildpunkt in mindestens zwei Unterpunkte unterteilt ist.

Der Nachteil der vorstehend beschriebenen Elektrolumineszenzvorrichtungen besteht darin, daß der erzielte optische Wirkungsgrad für viele Anwendungen zu gering ist.

Ein weiterer Nachteil besteht darin, daß das Emissionspektrum dieser bekannten Vorrichtungen in einem ungünstigen Wellenlängenbereich liegt und daher nur sehr intensitätsschwache Farbumwandlung betrieben werden kann.

Die Aufgabe der Erfindung besteht darin, eine Elektrolumineszenzvorrichtung der eingangs genannten Art zu schaffen, mit der ein möglichst hoher optischer Wirkungsgrad erreicht werden kann.
Weitere Aufgabe der Erfindung ist es daher, eine Elektrolumineszenzvorrichtung hoher Lichtausbeute mit sehr guten Farbwandeleigenschaften anzugeben.

Erfindungsgemäß wird dies dadurch erreicht, daß die Elektrolumineszenzschicht langkettiges Oligophenylen in Form einer Verbindung der Formel 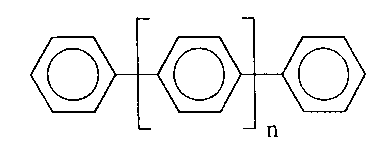 wobei n=2-20, umfaßt.

Oligophenyle wurden bereits als lichtemittierende Schichten in Elektrolumineszenzvorrichtungen erfolgreich eingesetzt (W. Graupner et al., Mol. Cryt. Liq. Cryst. 256 (1994) 549), welche jedoch maximal die Länge des Hexaphenyls erreichten und den Großteil ihrer Lichtemission im UV-Bereich haben, der somit für das menschliche Auge nicht nur unsichtbar sondern auch schädlich ist. Längere Verbindungen, wie sie Gegenstand der Erfindung sind, konnten bisher noch nicht realisiert werden.

Die erfindungsgemäßen, langkettigen Oligophenyle zeichnen sich durch die Aussendung von Licht im blauen Spektralbereich aus und sind daher hervorragend für die Anwendung in Bildschirmen oder in sonstigen Leuchtanzeigen geeignet. Durch die gute Farbwandeleffizienz können auch sehr lichtstarke andere Farben erzielt werden.

In weiterer Ausbildung der Erfindung kann vorgesehen sein, daß das Oligophenylen ein fluoriertes Oligophenylen der Formel 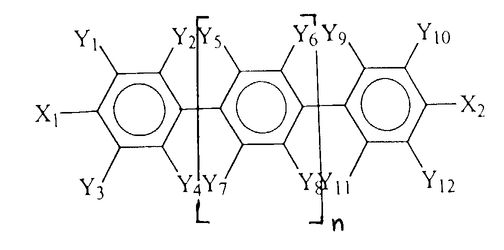 wobei n=2-20 (X₁,X₂, Y_{1...12}:-H, -F, -Alkyl, -Cl, -N, -CF₃, -CN) ist.

Die erfindungsgemäß fluorierten Oligophenyle stellen eine völlige neue Materialklasse dar, welche sich durch eine besonders hohe Elektronenbeweglichkeit auszeichnet.

Ein weiterer Nachteil bisher bekannter Elektrolumineszenzvorrichtungen besteht darin, daß durch unerwünschte Nebeneffekte der Elektronentransport von der Kathode in die aktive Schicht nur mit relativ großen Verlusten erfolgt und die Kathode dadurch nur eine geringe Stabilität bzw. Lebensdauer aufweist.

Die Aufgabe der Erfindung besteht daher darin, eine Elektrolumineszenzvorrichtung der eingangs genannten Art zu schaffen, mit der eine möglichst effiziente Beförderung der über die Elektronen injizierten Elektronen in die aktive Schicht ermöglicht wird.

Erfindungsgemäß wird dies dadurch erreicht, daß die Elektroneninjektionsschicht eine Verbindung der Formel 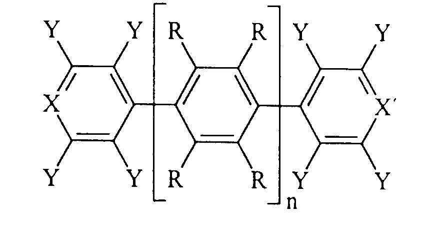 in welcher X, X'= -CCF₃; - CH; -N; -CNH₂; -CCN; -CF; -CBr; und Y, R = H, F; n= 0, 1,...,6; ist, und/oder eine Verbindung der Formel 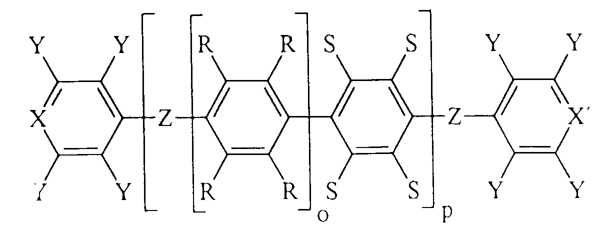 in welcher X, X'= -CCF₃; - CH; -N; -CNH₂; -CCN; -CF; -CBr; Y, R, S = H, F; Z=-CH=CH-, -N=CH-; -naphtalen, -perylen, quarterylen, -porphin, -phtalocyanin; o=0, 1; p= 0, 1, 2; ist, umfaßt.

Die erfindungsgemäße Schicht weist eine sehr hohe Elektronenbeweglichkeit auf, wodurch die Stabilität einer mit dieser Schicht aufgebauten Elektrolumineszenzvorrichtung gegenüber den bisher bekannten dieser Art signifikant verbessert werden kann, da die sonst durch lokale Temperatureffekte oder Elektronenwanderungsprozesse entstehenden Degradationsprozesse an der Kathode stark vermindert werden können.

In weiterer Ausbildung der Erfindung kann vorgesehen sein, daß die Löcherinjektionsschicht Poly- oder Oligoazomethin-ähnliche Verbindungen der Formel 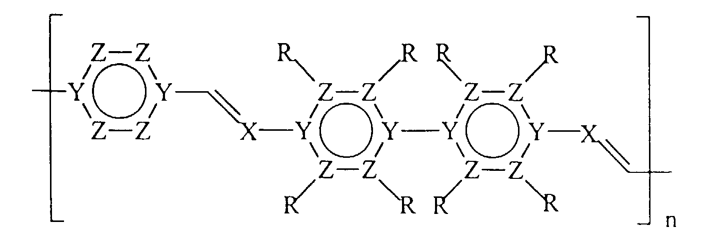 wobei Y, Z= -CCF₃; -CH; -N; -CNH₂; -CCN; -CF; -CBr;R; -H; -alkyl, -CN; X=-CH; -N;--CF, -CCl umfaßt.

Durch eine solcherart gebildete Schicht kann die Löcherinjektion von der Anode in die aktive Schicht verbessert werden, da die verschiedenen Löscheffekte, welche die Löcher noch vor dem Zusammentreffen mit den Elektronen in der aktiven Schicht vernichten, unterbunden werden.

Nach einem weiteren Merkmal der Erfindung kann vorgesehen sein, daß jeweils zwischen der Anoden- oder Kathodenschicht und der Elektrolumineszenzschicht bzw. der Elektronen- oder Löchertransportschicht eine aus silanisierten Verbindungen, z.B. ClSi, gebildete Schicht angeordnet ist.

Durch solche Verbindungen kann die Haftvermittlung durch die erste Monomerlage verbessert werden.

Die Erfindung betrifft weiters einen Elektrolumineszenz-Farbbildschirm mit Matrix-Bildpunkten bestehend aus einem Mehrschichtsystem von übereinander und teilweise nebeneinander aufgetragenen Einzelschichten, welches eine isolierende, optisch zumindest transluzente Grundschicht, eine leitfähige, optisch zumindest transluzente, streifenförmig strukturierte Grundelektrodenschicht, eine organische Elektrolumineszenzvorrichtung, eine streifenförmig strukturierte Deckelektrodenschicht, gegebenenfalls eine oder mehrere matrixartig aufgetragene Farbwandlerschichten und eine oder mehrere Passivierungsschichten umfaßt.

Mit bisher bekannten Farbbildschirmen dieser Art konnte nur ein im Vergleich zu konventionellen Bildschirmen schlechter Kontrast erzielt werden, der von einer nicht befriedigenden Bildpunktschärfe begleitet war.

Aufgabe der gegenständlichen Erfindung ist es daher, einen Farbbildschirm anzugeben, mit dem ein höherer Bildkonstrast und eine bessere Strukturierung des Farbbildes erzielbar ist. Erfindungsgemäß wird dies dadurch erreicht, daß - in Emissionsrichtung des Lichtes gesehen - jeweils nach der Grundschicht oder nach der oder den Farbwandlerschicht(en) eine oder mehrere spektral selektive Spiegel/Transmitter-Schichten zur spektralen Reinigung und Effizienzsteigerung des Emissionsspektrums angeordnet ist bzw. sind.

Dadurch wird der hochenergetische Spektralanteil des Lichtes so lange von der oder den Spiegel/Transmitter-Schichten zurückreflektiert, bis die Farbumwandlung in den Farbwandlerschichten soweit vollzogen worden ist, daß eine Steigerung des Umwandlungsgrades erreicht werden kann. Aus diesem Grund sind die aus der einen Grundfarbe umgewandelten anderen Grundfarben mit einer höheren Leuchtstärke verfügbar, was den Bildkontrast entscheidend anhebt.

Gemäß einer Variante der Erfindung können die spektral selektiven Spiegel/Transmitter- Schichten aus Schichten mit abwechselnd hohem und niedrigem optischen Brechungsindex gebildet sein, wobei vorzugsweise die Schicht mit hohem optischen Brechungsindex jeweils aus TiO₂ und die Schicht mit niedrigem Brechungsindex jeweils aus MgF₂ gebildet ist.

Dadurch wird ein dielektrischer Bandpaß gebildet, welcher nur Licht eines engen Wellenlängenbereiches durchläßt, während andere Wellenlängen zurückreflektiert werden.

In weiterer Ausbildung der Erfindung kann - in Emissionsrichtung des Lichtes - nach der Grundschicht und/oder den Farbwandlerschichten eine hochtransparente Schutzschicht angeordnet sein.

Dadurch kann einerseits eine optische Anpassung an den Brechungsindex benachbarter Schichten und gleichzeitig ein Höhenausgleich zwischen unterschiedlich hohen Schichten vorgenommen werden.

Weiters können eine oder mehrere Isolierschichten zwischen den Schichten vorgesehen sein, wodurch sich eine thermische Trennung der Farbwandlerschichten erreichen läßt, sodaß eine gegenseitige Beeinflussung der Farbwandlerschichten verhindert werden kann.

In weiterer Ausbildung der Erfindung kann vorgesehen sein, daß die Grundschicht aus einzelnen in Emissionsrichtung des Lichtes angeordneten Lichtleitern gebildet ist.

Bei einer solchen Ausbildung der Grundschicht, die einer optischen Multichannel-Platte gleicht, kann eine besonders ausgeprägte Ausrichtung der emittierenden Strahlung festgestellt werden.

Nach einer anderen Variante der Erfindung kann vorgesehen sein, daß die streifenförmige Grundelektroden- und die Deckelektrodenschicht jeweils einmal unterbrochen sind.

Weiters können die Moleküle der fluoreszierenden Farbstoffe der Farbwandlerschichten matrixartig und voneinander isoliert eingebaut sein, wobei die Matrix z.B. durch PMMA, Polystyrol gebildet ist.

Dadurch kann eine homogene Verteilung der Farbstoffe und eine sehr wirkungsvolle Farbumwandlung erzielt werden.

Gemäß einer anderen Variante können die aus fluoreszierenden Farbstoffen gebildeten Farbwandlerschichten chemisch als Seitenketten an ein Trägerpolymer gebunden sein.

Dadurch kann eine Aggregatbildung von Farbstoffen in den Farbwandlerschichten vermieden werden, ohne eine große Farbwandlerschichtdicke zu benötigen.

In weiterer Ausbildung der Erfindung kann oder können die Farbwandlerschicht(en) eine vorbestimmbare Orientierungsrichtung der Farbstoffmoleküle aufweisen.

Auf diese Weise läßt sich eine stärker gerichtete Emission des umgewandelten Lichtes aus der Farbwandlerschicht erzielen.

Gemäß einer anderen Variante der Erfindung kann die Deckelektrodenschicht aus zwei oder mehreren Stoffen gebildet sein.

Dadurch kann die Deckelektrodenschicht auf verschiedene Erfordernisse des erfindungsgemäßen Farbbildschirm besser abgestimmt werden. So kann ein gut leitendes Material mit einem harten kombiniert werden, um eine Zerstörung der Deckelektrodenschicht bei der Kontaktierung zu verhindern.

In weiterer Ausbildung der Erfindung kann vorgesehen sein. daß eine optisch polarisierende Farbwandlerschicht vorgesehen ist.

Dadurch kann in Kombination mit von anderen Farbwandlerschichten emittiertem polarisiertem Licht grüner und roter Farbe weißes Licht hoher Reinheit erzielt werden.

Weitere Aufgabe der Erfindung ist es, ein Verfahren zur Herstellung eines erfindungsgemäßen Farbbildschirms anzugeben, mit dem eine Verbesserung der Trennung der einzelnen Farbbildpunktflächen erreichbar ist.

Erfindungsgemäß wird dies dadurch erreicht, daß die Grundelektrodenschicht in parallelen Streifen auf die Grundschicht aufgetragen wird, daß darüber ein elektrisch isolierendes Material in parallelen Streifen orthogonal zu den parallelen Streifen der Grundelektrodenschicht aufgebracht wird, daß darauffolgend über und höhenversetzt zu den parallelen Streifen der Grundelektrodenschicht das aktive Elektrolumineszenzmaterial in parallelen Streifen aufgetragen wird, daß die Deckelektrodenschicht darauffolgend in parallelen Streifen senkrecht zu den Streifen der Elektrolumineszenzschicht und höhenversetzt über den Zwischenräumen der parallelen Streifen des elektrisch isolierenden Materials aufgebracht wird.

Daraus ergibt sich eine sehr gute Trennung der einzelnen Bildpunkte und damit eine Verbesserung der Bildschärfe. Weiters werden auch Kurzschlüsse zwischen den einzelnen Elektroden wirkungsvoll verhindert.

In weiterer Ausbildung der Erfindung kann vorgesehen sein, daß auf die aktive Elektrolumineszenzschicht eine lichtempfindliche Elektroneninjektionsschicht flächig aufgebracht und in parallelen Streifen belichtet wird, wodurch sie an diesen Stellen zum Isolator wird, und daß darauffolgend die Deckelektrodenschicht streifenförmig strukturiert wird.

Dadurch kann die Elektroneninjektionsschicht für die Gestaltung des Bildschirmes in vorteilhafter Weise mitbenutzt werden.

Weitere Aufgabe der Erfindung ist es, ein Verfahren zur Herstellung eines erfindungsgemäßen Farbbildschirmes anzugeben, mit dem sowohl eine Elektronen- als auch eine Löcherinjektionsschicht auf einfache Weise herstellbar sind.

Dies wird erfindungsgemäß dadurch erreicht, daß die Grundelektrodenschicht, die Lochinjektionsschicht und die aktive Elektrolumineszenzschicht in übereinanderliegenden parallelen Streifen auf die Grundschicht aufgebracht werden, daß die Elektroneninjektionsschicht und die Deckelektrodenschicht darauffolgend flächig aufgebracht, vorzugsweise aufgedampft, und dann in parallelen Streifen orthogonal zu den Streifen der Grundelektrode streifenförmig strukturiert werden, wobei die aktive Elektrolumineszenzschicht mitstrukturiert wird.

Weitere Aufgabe der Erfindung ist es, eine Vorrichtung zur Erzeugung von polarisiertem, weißem Licht durch Umwandlung von Licht einer, insbesondere aus organischen Materialien gebildeten Elektrolumineszenzvorrichtung mit der Grundfarbe Blau zu erzeugen.

Dies wird erfindungsgemäß dadurch erreicht, daß - in Emissionsrichtung des Lichtes gesehen - orientierte Farbwandlerschichten angeordnet sind, in denen Farbstoffe mit einer optischen Vorzugsrichtung enthalten sind, die vorzugsweise in einer Flüssigkristall-Matrix ausrichtbar sind.

Das von den Farbwandlerschichten emittierte Licht ist polarisiert, unabhängig davon, ob das Licht der Elektrolumineszenzvorrichtung polarisiert ist oder nicht. Für unpolarisiertes blaues Licht der emittierenden Elektrolumineszenzvorrichtung sind die Farbstoffe so aufgebaut, daß die Farbstoffe im blauen Spektralbereich nur senkrecht zur Molekülachse absorbieren, durch einen intramolekularen Energietransfer aber das farbgewandelte Licht entlang der Vorzugsrichtung der Molekülachse emittieren. Dadurch wird das farbgewandelte blaue Licht mit dem transmittierten blauen Licht in Richtung der Molekülachse überlagert, wodurch bei Kombination mehrerer gewandelter Farben mit der blauen Farbe weißes Licht entsteht.

In weiterer Ausbildung der Erfindung kann vorgesehen sein, daß - in Emissionsrichtung des Lichtes gesehen - ein oder mehrere spektral selektive Spiegel/Transmitterschichten angeordnet sind.

Dadurch ist eine wesentliche Verbesserung der Spektralreinheit des ausgesendeten Lichtes erreichbar, wobei die Ausbeute der Farbumwandlung deutlich erhöht wird.

Weiters kann gemäß einer erfindungsgemäßen Ausführungsform das emittierte blaue Licht der Elektrolumineszenzvorrichtung polarisiert sein.

Dabei wird die blaues Licht emittierende, erfindungsgemäße Vorrichtung mit einer oder mehreren orientierten Farbwandlerschicht(en) bedeckt, deren Dichte so gewählt wird, daß ein Teil des blauen Anregungslichtes die Farbwandlerschichten ohne Farbumwandlung durchdringen kann, sodaß zusammen mit den gewandelten Anteilen des Lichtes weißes polarisiertes Licht entsteht.

Nachfolgend wird die Erfindung anhand von in den Zeichnungen dargestellten Ausführungsbeispielen eingehend erläutert. Es zeigt dabei
Fig.1 einen Grundriß einer Ausführungsform eines erfindungsgemäßen Farbbildschirmes;
Fig.2 einen teilweisen Schnitt AA durch einen Farbbildschirm gemäß Fig.1;
Fig.3 einen teilweisen Schnitt BB durch einen Farbbildschirm gemäß Fig.1;
Fig.4 einen Schrägriß einer erfindungsgemäßen Elektrolumineszenzvorrichtung;
Fig.5, 6 und 7 chemische Strukturen der Elektrolumineszenzschicht einer erfindungsgemäßen Elektrolumineszenzvorrichtung;
Fig.8. 9 chemische Strukturen der Elektroneninjektionsschicht einer erfindungsgemäßen Elektrolumineszenzvorrichtung;
Fig.10 eine chemische Struktur der Löcherinjektionsschicht einer weiteren erfindungsgemäßen Elektrolumineszenzvorrichtung;
Fig.11 bis 15 eine schematische Darstellung der Verfahrensschritte zur Herstellung einer weiteren Ausführungsform eines erfindungsgemäßen Farbbildschirmes;
Fig.16 bis 18 eine schematische Darstellung der Verfahrensschritte zur Herstellung einer weiteren Ausführungsform eines erfindungsgemäßen Farbbildschirmes;
Fig.23 und 24 eine schematische Darstellung der Verfahrensschritte zur Herstellung einer Ausführungsform eines erfindungsgemäßen Farbbildschirmes;
Fig. 19 bis 22 eine schematische Darstellung der Verfahrensschritte zur Herstellung einer weiteren Ausführungsform eines erfindungsgemäßen Farbbildschirmes;

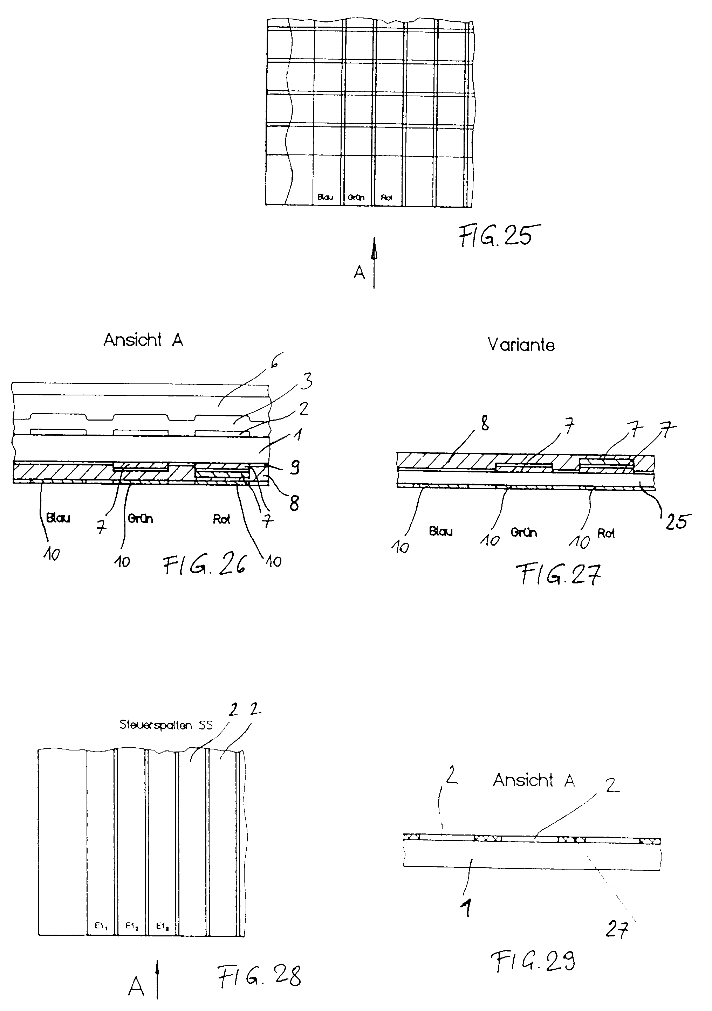

Fig.25 bis 27 eine schematische Darstellung der Verfahrensschritte zur Herstellung einer weiteren Ausführungsform eines erfindungsgemäßen Farbbildschirmes;
Fig.28 und 29, 30 eine schematische Darstellung der Verfahrensschritte zur Herstellung einer weiteren Ausführungsform eines erfindungsgemäßen Farbbildschirmes;

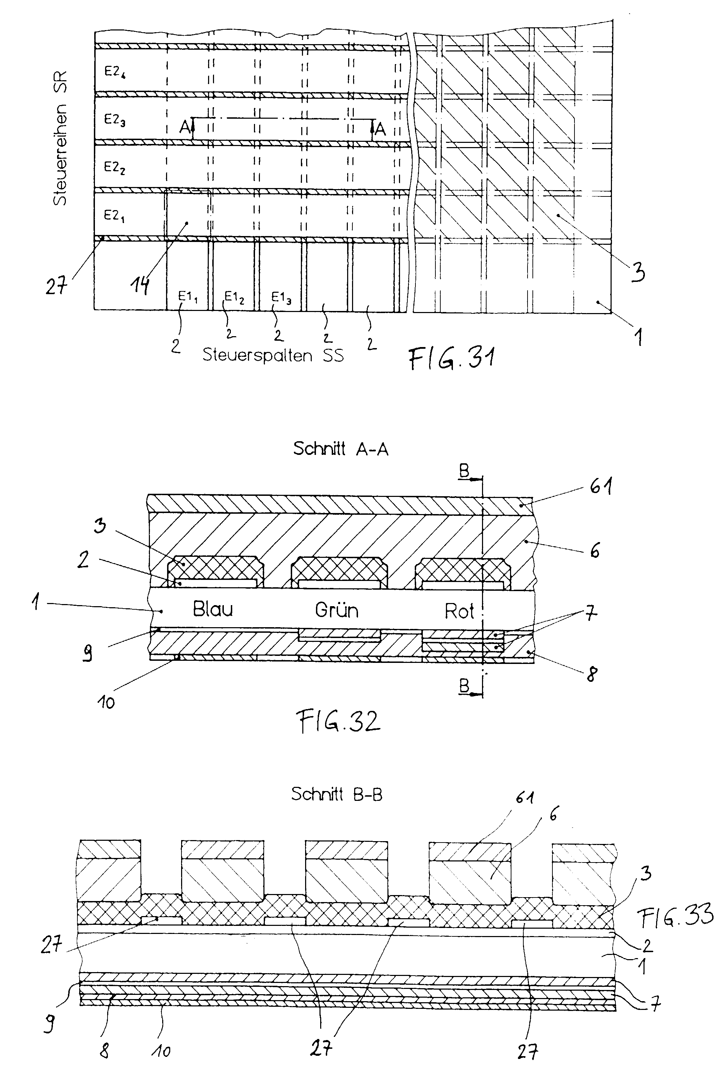

Fig.31 bis 33 eine schematische Darstellung der Verfahrensschritte zur Herstellung einer weiteren Ausführungsform eines erfindungsgemäßen Farbbildschirmes;

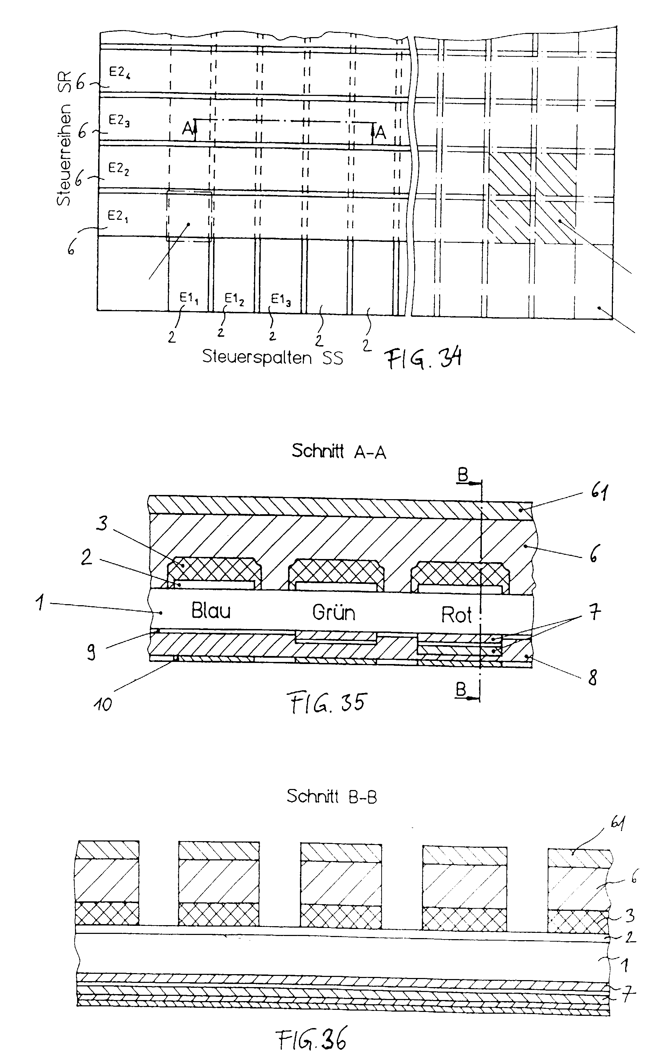

Fig.34 bis 36 eine schematische Darstellung der Verfahrensschritte zur Herstellung einer weiteren Ausführungsform eines erfindungsgemäßen Farbbildschirmes und

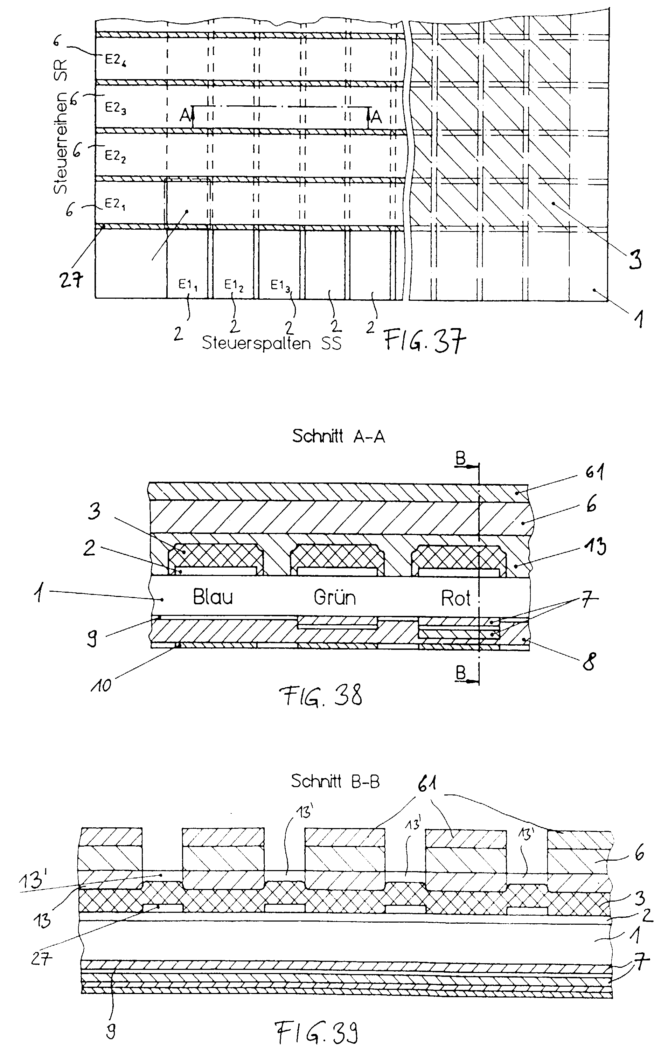

Fig.37 bis 39 eine schematische Darstellung der Verfahrensschritte zur Herstellung einer weiteren Ausführungsform eines erfindungsgemäßen Farbbildschirmes.

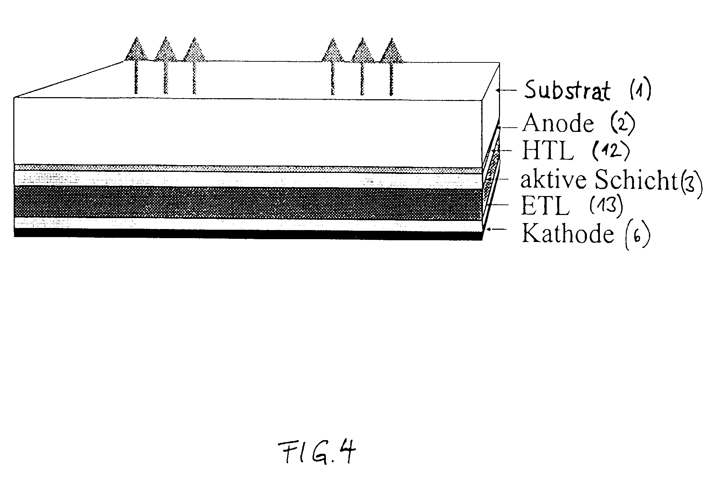

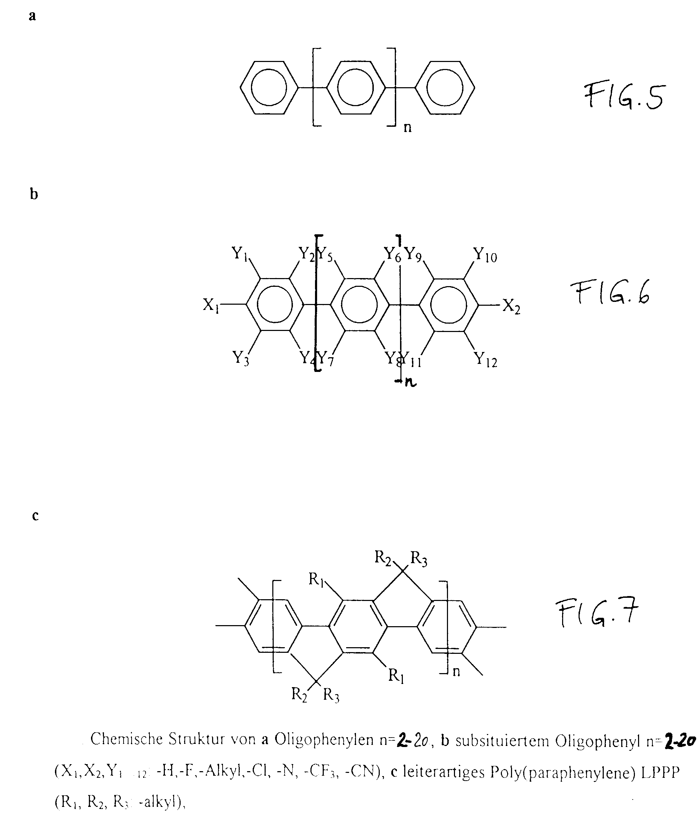

In Fig. 4 ist eine Elektrolumineszenzvorrichtung bestehend aus einem Mehrschichtsystem dargestellt, welches eine unter Einwirkung eines elektrischen Feldes Licht erzeugende aktive Elektrolumineszenzschicht 3 aus einem organischen Halbleiter umfaßt, die zwischen einer Elektronen in die Elektrolumineszenzschicht 3 injizierenden Kathodenschicht 6 und einer Löcher in die aktive Schicht injizierenden Anodenschicht 2 angeordnet ist.

Um die Lichtausbeute zu erhöhen, ist zwischen der Anodenschicht 2 und der Elektrolumineszenzschicht 3 eine Löcherinjektionsschicht 12 und zwischen der Kathodenschicht 6 und der Elektrolumineszenzschicht 3 eine Elektroneninjektionsschicht 13 angeordnet.

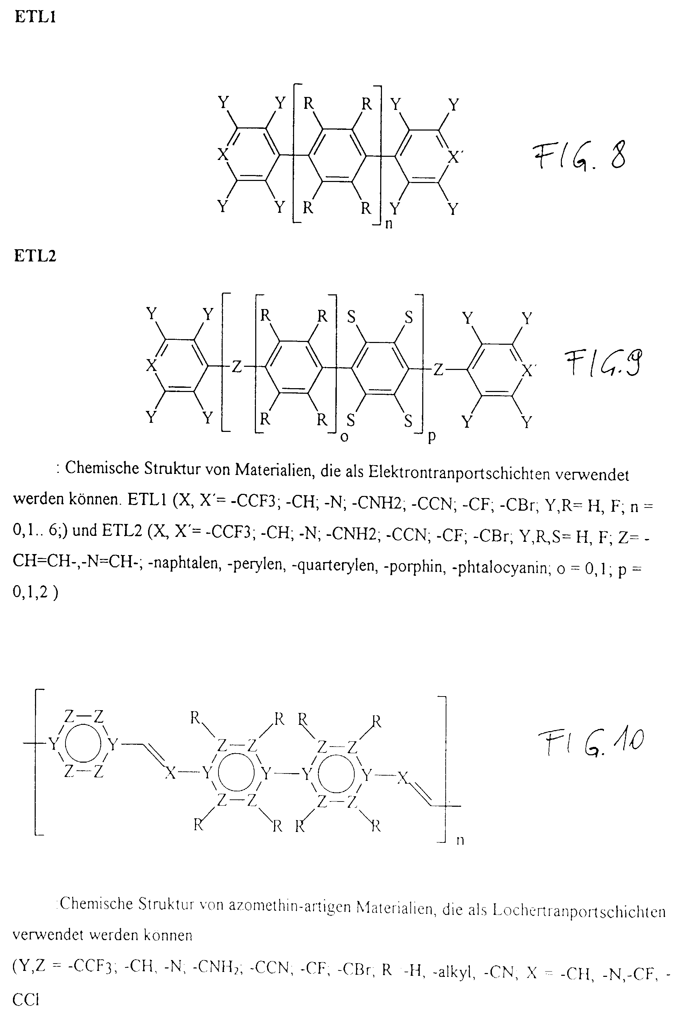

Erfindungsgemäß umfaßt die Elektrolumineszenzschicht 3 leiterartiges Poly(paraphenylen) (LPPP) mit alkylierten Seitenketten in Form einer Verbindung der Formel wie sie in Fig. 7 gezeigt ist, wobei R₁, R₂, R₃: -alkyl ist. Diese alkylierten Seitenketten verleihen dem LPPP eine sehr intensive Emissionsstrahlung im blauen Spektralbereich.

Eine weitere erfindungsgemäße Struktur für die Elektrolumineszenzschicht 3 ist aus Fig. 5 ersichtlich, welche aus langkettigem Oligophenylen (n=2-20) gebildet ist. Dadurch wird gegenüber den bekannten Oligophenylenen eine für das menschliche Auge sichtbare Strahlung erzielt, die sich hauptsächlich im blauen Spektralbereich erstreckt.

Weiters ist gemäß einer Variante der Erfindung vorgesehen, daß die Elektrolumineszenzschicht 3 fluoriertes Oligophenylen oder eine ähnliche chemische Verbindung umfaßt, wie es als chemische Strukturformel in Fig.6 mit substituiertem Oligophenylen n=2-20 (X₁,X₂, Y₁...₁₂:-H, -F, -Alkyl, -Cl, -N, -CF₃, -CN) dargestellt ist. Dieser bisher nicht herstellbare Stoff ermöglicht die Erzeugung von intensivem blauen Licht.

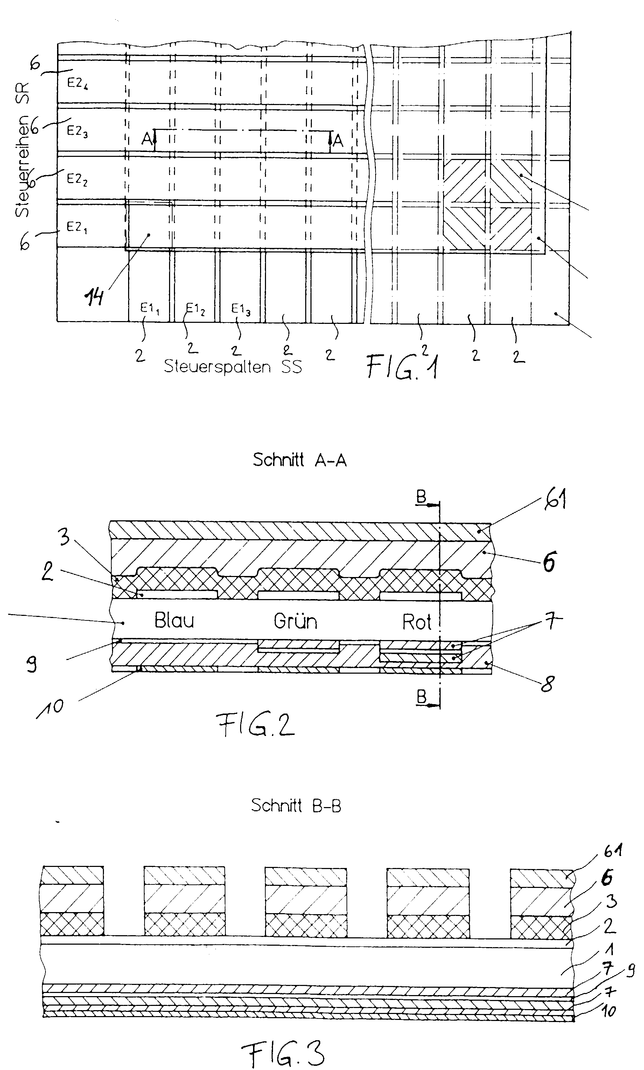

In den Fig. 1 bis 3 ist ein Elektrolumineszenz-Farbbildschirm mit Matrix-Bildpunkten bestehend aus einem Mehrschichtsystem von übereinander und teilweise nebeneinander aufgetragenen Einzelschichten dargestellt, welches eine isolierende, optisch transparente, zumindest transluzente Grundschicht 1 mit mehreren Schichten auf ihren beiden Deckflächen umfaßt. Auf der einen Seite der Grundschicht 1 ist eine leitfähige, optisch transparente, zumindest transluzente, streifenförmig strukturierte Grundelektrodenschicht 2 aufgebracht, darauffolgend eine organische Elektrolumineszenzschicht 3 mit parallelen Streifen normal zu den Grundelektrodenstreifen 2 und eine zu den Grundelektrodenstreifen 2 ebenfalls normale streifenförmig strukturierte Deckelektrodenschicht 6, während auf der gegenüberliegenden Seite der Grundschicht 1 mehrere matrixartig aufgetragene Farbwandlerschichten 7 aufgetragen sind. Die Schichten 2, 3 und 6 entsprechen der in Fig. 4 dargestellten Elektrolumineszenzvorrichtung, die somit Bestandteil des erfindungsgemäßen Farbbildschirmes ist. Es können dafür aber auch andere Vorrichtungen dieser Art in den Bildschirm eingebaut werden.

Erfindungsgemäß ist nun vorgesehen, daß - in Emissionsrichtung des Lichtes gesehen - jeweils nach der Grundschicht 1 oder nach der bzw. den Farbwandlerschichten 7 eine oder mehrere spektral selektive Spiegel/Transmitter-Schichten 10 zur spektralen Reinigung und Effizienzsteigerung des Emissionsspektrums angeordnet sind.

Gemäß Fig. 2 wird die optisch transparente Elektrodenschicht 2 in parallelen äquidistanten Streifen auf die optisch transparente, zumindest transluzide Grundschicht 1 aufgebracht, welche den Grundkörper für den erfindungsgemäßen Farbbildschirm bildet. Auf die streifenförmige Elektrodenschicht 2 wird die organische elektrolumineszierende Schicht 3 ebenfalls streifenförmig aufgebracht, sodaß sie sich normal zu den parallelen Streifen der Elektrodenschicht 2 erstreckt. Im nächsten Schritt wird die Deckelektrode 6 in parallelen Streifen ebenfalls normal zu den Elektrodenstreifen 2 positioniert. Dies ergibt eine Schichtenanordnung, wie sie in Fig. 3 in Richtung der Grundelektroden und gemäß Fig.2 in Richtung der Deckelektroden 6 aufgebaut ist.

Auf der den Elektroden 2, 6 gegenüberliegenden Seite der Grundschicht 1 werden fluoreszierende Materialien in den Farbwandlerschichten 7 zur Realisierung der Primärfarben strukturiert aufgebracht, und schließlich die dielektrischen, spektral selektiven Spiegel/Transmitter-Schichten 10 darüber angeordnet.

Die parallelen Streifen der optisch transparenten Elektrodenschicht 2 bilden die Steuerspalten und die parallelen Streifen der Deckelektrode 6 die Steuerreihen des erfindungsgemäßen Farbbildschirmes. Die projizierten Schnittflächen der beiden Elektroden 2, 6 definieren Bildpunktflächen 14, wie in Fig.1 zu ersehen ist. Dabei repräsentiert jede Bildpunktfläche eine der drei Primärfarben Rot, Blau und Grün. Die Breite der Steuerspalten 2 ist abhängig vom geforderten Auflösungsvermögen des aufzubauenden Bildschirmes und gleich der Breite der Steuerreihen 6. Die durch die beiden Elektroden 2 und 6 generierten Bildpunktflächen haben in diesem Ausführungsbeispiel eine quadratische Form.

Jede Steuerreihe und -spalte kann einzeln mit einer variablen Spannung versorgt werden, um die Bildpunkte 14 einerseits betreiben und um andererseits ihre Helligkeit variieren zu können. Um zum Beispiel die in Fig.1 strichpunktiert umrandete Bildpunktfläche 14 zu aktivieren, wird also die mit E2₁ und die mit E1₁ gekennzeichnete Steuerreihe 6 und Steuerspalte 2 mit einer Spannungsquelle verbunden. Dem Betrachter erscheint der Bildpunkt 14 beispielsweise in der blauen Grundfarbe.
Durch Anlegen der Spannung an die Elektrode E1₂ oder E1₃ erhält man einen grünen oder roten Farbpunkt, beim gleichzeitigen Aktivieren der drei Steuerspalten E1₁, E1₂, E1₃ und der Steuerreihe E2₁, ergibt sich aus der Überlagerung der drei Primärfarben ein weißer Farbeindruck. Durch entsprechende Ansteuerung der Bildpunkte und der möglichen Variationen der Spannungsstärke können somit alle notwendigen oder erwünschten Farbeindrücke an jedem beliebigen Bildschirmpunkt realisiert werden. Die in diesem Ausführungsbeispiel realisierte Gruppierung der drei Primärfarbpunkte kann aber auch in einer anderen Form getroffen werden.

Zum Aktivieren einer ganzen Steuerreihe 6, z.B. E2₁, gibt es im Prinzip zwei Möglichkeiten, nämlich einerseits an diese Steuerreihe und an alle Steuerspalten 2 Spannung anzulegen, wodurch ein stehendes Bild einer ganzen Steuerreihe 6 bewirkt wird, und andererseits Bildpunkt 14 für Bildpunkt 14 durch die zugehörigen Steuerspalten 2 zeitlich hintereinander anzuschalten, mit einer Frequenz, die über der Trägheit des menschlichen Auges liegt, wodurch sich ebenfalls ein stehendes Bild einer Steuerreihe 6 ergibt.

Der entscheidende Nachteil der ersten Variante ist, daß die betreffende Steuerreihe 6 den gesamten Strom für alle Bildpunkte der Steuerreihe zur Verfügung stellen muß, also den Summenstrom der einzelnen Ströme durch die Bildpunkte über die einzelnen Steuerspalten gelieferten Ströme, was die mechanischen und thermischen Fähigkeiten der Deckelektrodenschicht 6 und des organischen, elektrolumineszierenden Mediums 3 überfordern würde. Bei einer solchen Anschaltung sollte nur eine begrenzte Anzahl von Bildpunkten gleichzeitig geschaltet werden.

Zum Aktivieren einer ganzen Steuerspalte 2, z.B. E1₁, gibt es nun auch die Möglichkeit, Spannung an alle Steuerreihen 6 gleichzeitig anzulegen. wobei hier der vorstehend erwähnte Nachteil noch stärker zum Tragen kommt, da die optisch transparenten Steuerspalten 2 2 einen größeren spezifischen Widerstand besitzen. Somit sollte auch in jeder Steuerspalte 2 nur eine begrenzte Anzahl von Bildpunkten aktiviert sein. Um ein stehendes Bild einer Steuerspalte zu erhalten, werden die Steuerreihen 6 daher üblicherweise in einer entsprechend hohen Frequenz hintereinander mit Spannung belegt.

Aufgrund dieser flexiblen Ansteuerung der Steuerreihen 6 und der Steuerspalten 2, der Anordnung sowie der Belegung der Bildpunkte 14 mit den drei Primärfarben kann jedes erwünschte, flächige Farbbild am erfindungsgemäßen Bildschirm erzeugt werden.

Der erfindungsgemäße Farbbildschirm basiert somit auf einer blau leuchtenden organischen Leuchtdiode, deren Emissionsfarbe durch Farbkonversionsschichten teilweise in die Grundfarben grün oder rot umgewandelt wird. Das entstehende Emissionslicht wird nachfolgend durch die dielektrischen, spektral selektiven Spiegel/Transmitterschichten 10 spektral gereinigt werden, so daß jede Grundfarbe mit sehr hoher Lichtstärke erzeugt werden kann.

Die in Fig. 4 dargestellte organische Leuchtdiode besteht grundsätzlich aus der organischen Elektrolumineszenzschicht 3, die zwischen den zwei verschiedenen Elektroden (Anode) 2 und (Kathode) 6 angeordnet ist. Durch Anlegen einer Spannung an diese Elektroden 2 und 6 werden Elektronen von der Kathode 6 und Löcher von der Anode 2 in das aktive Medium der Elektrolumineszenzschicht 3 injiziert. Die ungleichnamigen Ladungsträger triften unter dem angelegten Feld in unterschiedliche Richtungen und können daher in der aktiven Elektrolumineszenzschicht 3 miteinander wechselwirken, um angeregte Zustände zu bilden. Die angeregten Zustände können strahlend in den Grundzustand zurückkehren und dadurch das Elektrolumineszenzlicht erzeugen.

Um effiziente Elektrolumineszenz zu erzeugen, ist es nötig, daß die Austrittsarbeiten der beiden Elektroden 2 und 6 einerseits gut mit der Valenzbandoberkante und anderseits gut mit der Leitfähigkeitsunterkante der aktiven Schicht übereinstimmen.

Um eine möglichst gute Elektroneninjektion von der Kathode 6 zu gewährleisten, soll das Kathodenmaterial gute Leitfähigkeit und eine an das aktive Medium 3 angepaßte und daher möglichst geringe Austrittsarbeit, z.B. <4-4.5eV besitzen. Da besonders Materialien mit geringen Austrittsarbeiten üblicherweise sehr reaktiv sind, z.B. Alkali- und Erdalkalimetalle, ist zusätzlich eine möglichst hohe Umgebungsstabilität des Kathodenmaterials gefordert. Einige Materialien, die als Kathodenmaterial verwendet werden können sind z. B. Al, Ag, Mg, Ca, In und Legierungen zwischen diesen Materialien.

Um eine möglichst gute Löcherinjektion von der Anode 2 zu gewährleisten, soll das Anodenmaterial gute Leitfähigkeit und eine möglichst hohe Austrittsarbeit, z.B. >4-4.5eV aufweisen. Einige Materialien, die als Anodenmaterial verwendet werden können sind z. B. Au, Pt, Cu. Des weiteren können durch Dotierung entartete Halbleiter, wie z. B. Indium-Zinn-Oxide (ITO), dotierte Zinkoxide, Indiumoxide und andere dotierte Halbleiter mit großer Energielücke und dotierte Filme konjugierten Polymere, z. B. dotiertes Polyanilin, verwendet werden. Die letztgenannten Materialien besitzen im Vergleich zu den Metallelektroden den Vorteil, daß sie hohe Transparenz im sichtbaren Spektralbereich aufweisen. Dies ist insoferne von Bedeutung, weil das im aktiven Medium der Elektrolumineszenzschicht 3 generierte Licht durch die Grundelektrode 2, welche die Anode bildet, emittiert wird und die optischen Verluste dabei möglichst gering sein sollen. Aus diesem Grund muß zumindest eine der beiden Elektroden 2, 6 transparent oder zumindest semitransparent ausgeführt werden. Es kann aber anstelle der Anode auch die Kathode transparent oder zumindest transluzent ausgeführt sein, und das erzeugte Licht so an die Außenwelt gelangen.

Im einfachsten Fall besteht das aktive Medium der Elektrolumineszenzschicht 3 aus einer organischen lichtemittierenden Schicht. Diese Schicht soll gute Ladungstransporteigenschaften, hohe Photolumineszenz- Quantenausbeute und eine geringe Defektkonzentration besitzen. Blau emittierende Leuchtdioden sind von besonderem Interesse, da das blaue Licht zur Anregung von Farbstoffschichten verwendet werden kann, wodurch das blaue Licht in grünes und rotes Licht umgewandelt werden kann.

Organische Materialien, die chemisch dem Oligo- oder Polyphenylen ähnlich sind, haben sich als besonders geeignet für die Anwendung in blauen LED herausgestellt. Erfindungsgemäß ist die Elektrolumineszenzschicht 3 durch die in den Fig.5, 6 und 7 dargestellten chemischen Strukturen gebildet. Durch die Anwendung von zusätzlichen Ladungstransportschichten 12, 13 zwischen der aktiven Schicht 3 und den Elektroden 2 und 6 können die Bauelemente gemäß Fig.4 entscheidend verbessert werden. Eine Ursache dafür ist, daß durch die Elektronen- bzw. Löcherinjektionsschichten 13, 12 die angeregten Zustände von den Elektroden 2 bzw. 6 isoliert werden, so daß das Löschen der Lumineszenz an Defektzuständen, die bevorzugt in der Nähe der Elektroden 2, 6 anzufinden sind, reduziert wird. Des weiteren kann durch Einsetzen dieser speziellen Ladungstransportschichten die Effizienz und die Lebensdauer der Bauelemente weiter verbessert werden.

Eine Ladungstransportschicht, die zwischen der aktiven Schicht 3 und der Kathode 6 angeordnet ist und hohe Elektronen- und nur eingeschränkte Löcherbeweglichkeit besitzt, wird als Elektroneninjektionsschicht 13 bezeichnet. Die Elektroneninjektion in die aktive Elektrolumineszenzschicht 3 kann durch eine Elektroneninjektionsschicht 13 entscheidend verbessert werden, wenn sich das LUMO-CB, das ist der niedrigste unbesetzte Molekülzustand der Elektroneninjektionsschicht 13 energetisch unterhalb des Leitfähigkeitsbandes der aktiven Schicht 3 aber über der Fermikante der Kathode 6 befindet. Durch die Elektroneninjektionsschicht 13 kann also die Elektroneninjektion kontrolliert werden, so daß die Anzahl der injizierten Elektronen der Amzahl der injizierten Löcher angeglichen werden kann und die Effizienz des Bauelementes dadurch entscheidend verbessert wird. Die Effizienz der Baulemente kann weiters dadurch verbessert werden, wenn sich das HOMO-VB, das ist das höchste besetzte Molekülniveau, der Elektroneninjektionsschicht 13 energetisch unterhalb des Valenzbandes der aktiven Elektrolumineszenzschicht 3 befindet. In diesem Falle werden Elektronen und Löcher an der Grenzfläche von Elektroinjektionsschicht und aktiver Schicht 3 lokalisiert und können daher besser miteinander wechselwirken, wodurch angeregte Zustände effizienter ausgebildet werden.

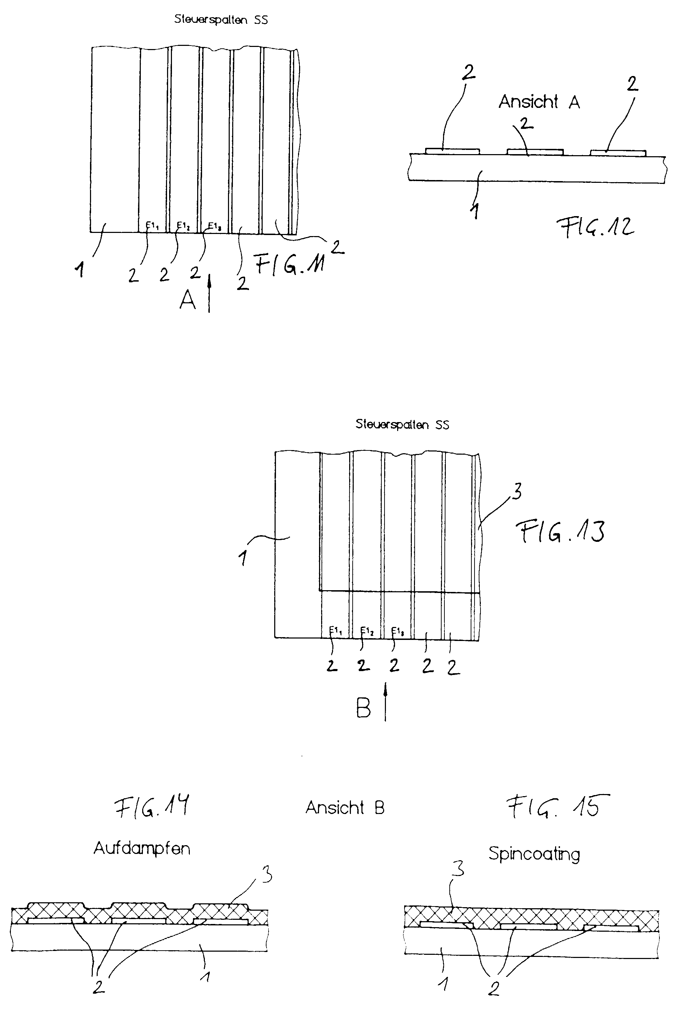

Bevorzugte Materialien zur Verwendung als Elektroneninjektionsschicht sind die organischen Molekülverbindungen in den Fig.8 und 9. Diese oligophenylartigen Verbindungen sind dadurch gekennzeichnet, daß sie gute Elektronentransporteigenschaften und geringe Absorption im sichtbaren Spektralbereich besitzen.

Eine Ladungstransportschicht, die zwischen der aktiven Elektrolumineszenzschicht 3 und der Anode 2 angeordnet ist und hohe Löcher- und nur eingeschränkte Elektronenbeweglichkeit besitzt, wird gemäß Fig.4 als Löcherinjektionsschicht 12 bezeichnet. Die Löcherinjektion in die aktive Schicht kann durch diese Schicht entscheidend verbessert werden, wenn sich das HOMO-VB der Löcherinjektionsschicht energetisch unterhalb der Fermikante der Anode 2 aber oberhalb des Valenzbandes der aktiven Schicht 3 befindet. Dadurch kann eine Absenkung der Operationsfeldstärke erzielt werden und die Lebensdauer der Bauelemente erhöht werden. Die Oligoazomethine (OAM) gemäß Fig.10 sind eine organische Materialklasse, die aufgrund ihrer guten Löchertransporteigenschaften besonders für die Anwendung als Löcherinjektionsschicht geeignet sind. Diese organischen Verbindungen können durch eine spezielle Herstellungstechnik hochorientiert auf polare Oberflächen aufgewachsen werden. Das OAM bildet sich durch eine stufenweise Polykondensation der einzelnen chemischen Bestandteile, die hintereinander verdampft werden. Die erste Monomermonolage reagiert chemisch mit den OI-I-Gruppen der polaren Oberfläche, sodaß sich das Monomer senkrecht zur Oberfläche anordnet. Die nachfolgend aufgedampften Verbindungen reagieren schließlich mit den zuvor gebildeten Schichten, wodurch sich eine OAM-Schicht ausbildet, in der die einzelnen Polymerketten senkrecht auf das Substrat stehen. Die Haftvermittlung durch die erste Monomerlage kann mittels Verbindungen, die verschieden silanisierte Endgruppen (z. B. ClSi) besitzen, verbessert werden.

Für die zumindest semitransparente Anode 2 sind - wie vorstehend beschrieben - leitende Materialien wie Indium-Zinnoxid (ITO), dotierte Polymere oder halbtransparente dünne Schichten aus Metallen mit hoher Austrittsarbeit wie Gold oder Platin bevorzugt. Als Kathodenmaterial für die Kathodenschicht 6 ist hingegen ein Material mit einer niedrigen Austrittsarbeit, z.B. Ca, Mg, Al vorteilhaft einsetzbar.

Vorrichtungen mit der Schichtenfolge Anode/aktive Schicht/Kathode in Form von ITO/LPPP/Al emittieren abhängig von der Betriebsspannung homogenes blau-grünes Licht bei einem λₘₐₓ = 461 nm mit einer Leuchtdichte von etwa 100 cd/m². In dieser an der Luft stabilen Konfiguration werden Quantenwirkungsgrade zwischen 0,1% und 1% beobachtet. Vorstehend beschriebene Vorrichtungen können signifikant verbessert werden, wenn passende Ladungs-Transport-Schichten 12, 13 zwischen der Anoden- bzw. Kathodenschicht 2. 6 und der aktiven Schicht 3 angeordnet werden.

Dadurch wird einerseits die Emissionszone von der Kathodenschicht isoliert, an der die Löschwahrscheinlichkeit sehr hoch ist und andererseits kann das Gleichgewicht der Ladungsinjektion in die aktive Schicht verbessert werden, sodaß die notwendige Betriebsspannung reduziert werden kann.

Die zwischen Anodenschicht 2 und aktiver Schicht 3 angeordnete Löcher-Transportschicht 12 wird durch Polykondensationsreaktionen von nacheinander abgelegten Monomeren gebildet, wobei hochorientierte Polyazomethinfilme auf polaren Oberflächen erhalten werden. Die dabei verwendeten Monomere sind Terephtaldehyde und methylierte Derivative von Phenylendiaminen und Benzidinen.

Die Löchertransportschicht 12 wird folgendermaßen aufgebracht. In einem ersten Absorptionschritt wird Terephtaldehyd auf ein Substrat bei ungefähr 105 °C und einer Substrattemperatur von 25°C abgelegt. Danach wird die Diamin-Komponente Tetramethylbenzidin bei einer Quellentemperatur von 140°C und bei einer Substrattemperatur von 25°C abgelegt, die mit dem Terephtaldehyd reagiert. Die Substrattemperatur wird hernach auf 170°C gesteigert, um sicher zu gehen, daß keine monomeren Verbindungen in der Schicht zurückbleiben. Die erste Schicht ist stark mit dem Substrat gebunden, sodaß zusätzliche Schichten durch Ablegen von Aldehyd- und Diamin- Komponenten gebildet werden können. Durch die Polykondensation wird Oligoazomethin (OAM) gebildet.

In ITO/OAM/PHP/Al-Mehrschichtsystemen wird das für das Einsetzen des Stromes in Durchlaßrichtung (ITO als Anode) erforderliche elektrische Feld unabhängig von der Dicke der PHP-Aktivschicht auf Werte um 0,3 MV/cm herabgesetzt, im Vergleich zu 0,8 MV/cm, die für Einfach-Schicht-PHP-Vorrichtungen ohne OAM-Löchertransportschicht notwendig sind. Das elektrische Feld bestimmt üblicherweise das Einsetzen des Stromes und damit die Elektrolumineszenz, weil das feldinduzierte Tunneln der Ladungsträger von den Elektroden in das Polymer der vorherrschende Injektionsmechanismus bei höheren angelegten Spannungen ist. Das Verkleinern der erforderlichen Treibfelder kann somit der reduzierten Barrierenhöhe für die Löcherinjektion an der ITO-Oberfläche zugeschrieben werden, wenn angenommen wird, daß der durch die Vorrichtung hindurchfließende Strom wie in den meisten organischen Vorrichtungen hauptsächlich durch Löcher, also positiv geladenen Polaronen, dominiert wird. Der erhöhte Elektrolumineszenz-Wirkungsgrad, der bis zu 2% betragen kann und die Leuchtdichte, die bis zu 360 cd/m² sein kann, für ITO/OAM/PHP/Al- Vorrichtungen kann den im Vergleich zu Einzelschicht-Vorrichtungen reduzierten Löscheffekten zugeschrieben werden. Das Löschen nimmt ab, weil die OAM-Schicht die nichtstrahlende Rekombination der Elektronen, welche negativ geladene Polaronen darstellen, an der ITO-Elektrode verhindern und weil die niedrigeren Treibfeldstärken auch eine Reduktion von thermischen und feldinduzierten Löschungsmechanismen bewirken.

Aus blauem Licht kann man alle anderen Farben herstellen, da die blaue Farbe die höchstenergetische aller Spektralfarben darstellt. Beleuchtet man einen Farbstoff, der grün emittiert, mit blauem Licht, so wird der grüne Farbstoff durch das blaue Licht angeregt und emittiert nachfolgend grünes Licht. Das Licht wird also von einer Farbe, die energetisch höher liegt, in eine Farbe die energetisch tiefer liegt, umgewandelt - dieser Prozeß ist das Grundprinzip der Photolumineszenz.

Dieser Effekt kann auch ausgenutzt werden, um das Licht einer blau emittierenden organischen Leuchtdiode in andere Farben umzuwandeln. Bedeckt man nämlich die blaue Diode mit einer oder mehreren verschiedenen Farbstoffschicht(en), so kann man alle sichtbaren Farben inklusive weiß und infrarot herstellen.

Bedeckt man eine erfindungsgemäß blaue LPPP- Leuchtdiode mit einer Schicht eines Coumarin 102 Farbstoffes in einer Polymetacrylat (PMMA)-Matrix wird das blaue Licht der LPPP Diode in grünes Emissionslicht umgewandelt, womit grünes Licht erzeugt wird, das dreimal so hell für das menschliche Auge wie das anregende blaue Licht erscheint, da das menschliche Auge im Grünen sehr viel empfindlicher ist. Die Quantenkonversionsausbeute von Blau auf Grün beträgt in diesem Fall ungefähr 40%. Wird die Farbstoffschicht direkt auf die Elektrolumineszenzschicht ohne Luftschicht dazwischen aufgebracht, kann die Quantenkonversionsausbeute bis auf 90 % erhöht werden, da dadurch Wellenleitungseffekte zwischen den Schichten minimiert werden. Die Erzeugung roter Emissionsfarben mittels blauem Licht ist schwieriger, da die meisten Farbstoffe, die im Roten emittieren, nur geringe Absorption im Blauen zeigen und daher mit blauem Licht nicht effizient angeregt werden können. Aus diesem Grund kann man einen roten Farbstoff mit einem grünen koppeln und die Farbkonversion von Blau→Grün→Rot erzielen.

Die anderen Grundfarben neben Blau, nämlich Rot und Grün, die für die Realisierung von Flachbildschirmen erfordlich sind, können beispielsweise folgendermaßen hergestellt werden:

Helle grüne Emission (CIE-Koordinaten x= 0,27, y=0,62) kann durch die Verwendung einer Farbstoffschicht Coumarin 102 mit einem Photolumineszenzwirkungsgrad von 93% in Poly(Methylenmethacrylat) PMMA mit einer hohen optischen Dichte größer 3 erzielt werden. Das anregende blaue Licht wird dann aufgrund der starken Absorption von Coumarin im blauen spektralen Bereich völlig in der Farbstoff-Matrix absorbiert. Die resultierende helle, grüne Emission von der in Fig.2 dargestellten, gestapelten Doppelschichtstruktur aus Farbwandlerschichten 7 setzt sich dabei durch das Photolumineszenzlicht vom Coumarinfarbstoff (90%) und durch den grünen Teil der PHP-Elektrolumineszenz-Emission zusammen. Der hauptsächliche Intensitätsverlust, der während der Farbumwandlung von Blau auf Grün auftritt, ist bedingt durch "waveguiding" und durch nachfolgende Auslöschung des Emissionslichtes innerhalb der Farbstoffschicht bedingt. Theoretisch kann der Konversionswirkungsgrad 100% erreichen.

Die Herstellung von effizienter Rotstrahlung ist schwieriger, da die spektrale Überlappung der Absorption der roten Farbstoffe mit der blauen Emission üblicherweise nur sehr gering ist. Daher wird eine rote Farbschicht 7 aus Lumogen F300, (Photolumineszenzwirkungsgrad 96%) mit einer grünen Coumarin-Farbstoffschicht 7 gekoppelt (Fig.2). Der rote Farbstoff absorbiert sehr stark im grünen Spektralbereich und wandelt daher die grüne Anregung in eine rote Photolumineszenz-Emission um.

Durch Einsatz des dielektrischen Bandpaßfilters in Form der Spiegel/Transmitterschicht 10 werden die anregenden blauen Wellenlängen gesperrt und spektral reines rotes Licht (CIE: x= 0,65, y= 0,34) kann erhalten werden.

Der Umwandlungswirkungsgrad von der blauen in die rote Emission ist ungefähr 10%, wenn PHP-Elektrolumineszenzvorrichtungen als Beleuchtungsquelle verwendet werden. Der beobachtete Intensitätsverlust kann hauptsächlich dem "waveguiding" innerhalb der roten Farbstoffschicht aber auch den Reflexionsverlusten des roten Lichtes im Interferenzfilter zugeschrieben werden.

Um das Licht spektral zu reinigen, könnte auch ein Absorptionsfilter verwendet werden, der alle Anteile mit Ausnahme der gewünschten Emissionswellenlängen absorbiert. Der Nachteil dieser Methode ist, daß die Lichtenergie, die außerhalb des gewünschten Wellenlängenbereiches in Wärmeenergie im Absorptionsfilter umgewandelt wird. Die Methode, die für den erfindungsgemäßen Farbbildschirm angewandt wird, um die Emissionsfarben nachträglich spektral zu reinigen, basiert daher auf dem nicht absorbierenden dielelektrischen Bandpaß aus einer Spiegel/Transmitterschicht. Diese dielektrische Spiegel/Transmitterschicht 10 (Fig.2) besteht aus mehreren Schichten von Materialien mit abwechselnd hohem und niedrigem Brechungsindex, z.B. Ti0₂ mit einem Brechungsindex n = 2,1 und MgF₂ n= 1,3. Der Spiegel/Transmitter besitzt hohe Transmission im gewünschten Emissionsbereich (T>80%) und hohe Reflexion im restlichen sichtbaren Spektralbereich (R>85%). Dadurch kann nur Licht in dem Spektralbereich, in dem der Spiegel/Transmitter hochtransparent ist, den Filter passieren, während das restliche Licht wieder zurückreflektiert wird. Der hochenergetische Anteil des reflektierten Lichtes wird daher zwischen der spektral selektiver Spiegel/Transmitterschicht 10 und der Grundelektrodenschicht 2 so lange hin und her reflektiert, bis es von den Farbstoffschichten absorbiert und umgewandelt wird. Mittels der spektral selektiven Spiegel/Transmitterschicht kann daher eine spektrale Reinigung mit minimalem Energieverlust erzielt werden.

Wie vorstehend beschrieben, werden für die Farbwandlerschichten 7 organische Farbstoffe mit hoher Photolumineszenzquantenausbeute (PLQA) verwendet. Um homogene Schichten herstellen zu können, werden die Farbstoffe in Polymermatrizen, wie z. B. PMMA, Polystyrol eingebettet. Die Farbwandlerschichten 7 müssen von hoher optischer Dichte sein, damit das Anregungslicht in der Schicht vollständig absorbiert wird. Die optische Dichte der Farbwandlerschicht 7 steigt mit der Konzentration des Farbstoffes in der Polymermatrix. Mit steigender Konzentration des Farbstoffes in Polymermatrizen steigt allerdings auch die Wahrscheinlichkeit zur Ausbildung von Farbstoffaggregaten, wodurch die PLQA der Farbstoffe drastisch abgesenkt wird. Dieser Konzentrationseffekt kann vermieden werden und die nötige optische Dichte trotzdem erzielt werden, wenn die Dicke der Farbwandlerfilme dementsprechend erhöht wird. Beim Aufbau des Bildschirmes muß jedoch berücksichtigt werden, daß sich dicke Farbwandlerschichten negativ auf das Auflösungsvermögen auswirken. Eine weitere Möglichkeit besteht darin, die Aggregatbildung zu minimieren, ohne dabei die Schichtdicke der Farbwandlerschichten zu erhöhen. Dies kann einerseits dadurch erreicht werden, indem man die Farbstoffmoleküle als Seitenketten an das Polymer bindet. Mit diesen Seitenkettenpolymeren kann man sehr dünne Filme mit hoher optischen Dichte und hoher PLQA realisieren. Eine andere Möglichkeit die Aggregatbildung zu minimieren, besteht darin, die Farbstoffe in einer speziellen kristallinen (z.B. lyotropen) Matrix anzuordnen, in der die Farbstoffmoleküle voneinander isoliert vorliegen. In Matrizen, in der sich die Farbstoffmoleküle in senkrechten zylindrischen Strukturen, die in diesen eingebettet sind, anordnen, ist die Emission stärker gerichtet als in einer isotropen Polymermatrix, sodaß in solchen Matrizen das Auflösungsvermögen erhöht wird.

Die oben beschriebene Farbumwandlungsmethode kann auch dazu verwendet werden, polarisiertes vielfarbiges Licht zu erzeugen. Die Farbwandlerschichten müssen in diesem Fall Farbstoffe mit einer Vorzugsrichtung enthalten, die in der flüssigkristallinen Matrix ausgerichtet werden können. Das Licht, das von diesen Farbwandlerschichten 7 dann emittiert wird, ist dann unabhängig ob die Pumpquelle polarisiert ist oder nicht, polarisiert.

Schwieriger ist die Herstellung von polarisiertem weißen Licht, da die weiße Emission den ganzen sichtbaren Spektralbereich überstreicht. Die Erzeugung von weißem polarisierten Licht kann mittels folgender Methoden realisiert werden:
(i) Die polarisiertes blaues Licht emittierende organische Leuchtdiode wird mit einer oder mehreren orientierten Farbwandlerschicht(en), bestehend aus anisotropen Farbstoffen, bedeckt. Die optische Dichte der orientierten Farbwandlerschichten wird so gewählt, daß ein Teil des blauen Anregungslichtes die Farbwandlerschichten durchdringen kann, und somit zusammen mit den von den Farbwandlerschichten konvertierten Anteilen weißes polarisiertes Licht erzeugt.
(ii) Die unpolarisiertes blaues Licht emittierende organische Leuchtdiode wird mit einer oder mehreren orientierten Farbwandlerschicht(en) bedeckt. Die Farbstoffe der Farbwandlerschichten sind so aufgebaut, daß die Farbstoffe senkrecht zur Molekülachse im Blauen absorbieren, durch einen intramolekularen Energietransfer aber entlang der Vorzugsrichtung der Molekülachse emittieren (z. B. Lumogen, registrierte Marke der Firma BASF). Bedeckt man die blaue Leuchtdiode daher mit einer (oder mehreren) solchen orientierten Farbwandlerschicht(en), so absorbieren diese Farbstoffe bevorzugt blaues Licht, das senkrecht zur Molkülachse und damit zur Vorzugsrichtung orientiert ist, und emittieren Licht in Richtung der Molekülachse. Da das blaue Licht in den orientierten Farbwandlerschichten bevorzugt senkrecht zur Molekülachse absorbiert wird, ist das transmittierte blaue Licht ebenfalls in Richtung der Vorzugsrichtung der Farbwandlerschicht polarisiert. Das transmittierte blaue Licht und das von der (den) Farbwandlerschicht(en) emittierte grüne und rote Licht haben daher gleiche Polarisationsrichtung, so daß bei geeigneter Konzentration der Farbstoffe in der Matrix, polarisiertes weißes Licht erzeugt werden kann.

Die Anforderungen an die für die optisch zumindest transluzente, leitfähige Elektrode 2, wie eine nahzu 100% optische Transparenz, eine gute Leitfähigekeit, eine passende Austrittsarbeit und Robustheit gegen thermische und mechanische Belastungen werden durch Indiumoxid In₂O₃ als bevorzugtem Material erfüllt.

Die Elektrode 2 wird gemäß Fig.11 entweder als kontinuierliche Schicht oder strukturiert als Maske auf die Grundschicht 1 aufgedampft, die Schichtdicke kann bis zu 1 µm betragen. Strukturiert wird mit Hilfe photolithographischer Verfahren, wobei das detaillierte Belichten auf verschiedene Art und Weise erfolgen kann.

Beispiele dafür sind:
- Belichten der Streifen mit einem He-Cd-Laser
- Erzeugen eines holographischen Gitters
- Strichmaske auf transparentem Medium

Nach den notwendigen Ätzschritten und dem Entfernen des verbliebenen Photoresist-Lackes, der zum Abdecken verwendet worden ist, erhält man die strukturierte Elektrodenschicht 2 auf der Grundschicht 1 (Fig.12).

Das aktive Medium der Elektrolumineszenz-Schicht 3 kann aus einem einzelnen oder aus einer Kombination von verschiedenen Stoffen bestehen, um die erwünschten Eigenschaften zu erhalten.

In Abhängigkeit vom verwendeten aktiven Material erfolgt das Aufbringen entweder durch Aufdampfen, Aufstreichen oder durch Spincoating, wobei die Schichtdicke des gesamten aktiven Paketes bis zu 1µm beträgt. Beim Aufbringen ist darauf zu achten, das die Enden der Steuerreihen 6 und der Steuerspalten 2 gemäß Fig.13 durch einfaches Abdecken der entsprechenden Flächen frei bleiben, da an diesen Stellen die Kontaktierung erfolgt. Das Aufbringen des aktiven Mediums auf die nivellierte Oberfläche der strukturierten Elektrode 2 bereitet bei den verwendeten Schichtdicken des aktiven Mediums keinerlei Probleme (Fig.14). Beim Spincoaten der aktiven Schicht 3 wird die Nivellierung der Elektrode 2 ausgeglichen und man erhält eine ebene obere Fläche der aktiven Schicht (Fig.15).

Die verwendbaren Materialien müssen neben einer guten Leitfähigkeit auch eine passende Austrittsarbeit und hohes Refelxionsvermögen aufweisen. Auch hier können verschiedene Materialien und Materialkombinationen eingesetzt werden, wobei Schichtdicken bis zu 1 um Verwendung finden.

Prinzipiell lassen sich verschiedene Techniken zum Strukturieren des erfindungsgemäßen Mehrschichtsystems (Fig.16 bis 18) anwenden. Im Ausführungsbeispiel gemäß den Fig. 19 bis 22 wird zuerst ein kontinuierliches Aufbringen und anschließendes Strukturieren vorgenommen. Zum gezielten Abtragen der Zwischenräume 17 in der Deckelektrode 6 kommen Sputterverfahren, z.B. mit Elektonenstrahl oder lonenstrahl, Laserabtragung und Lithographieverfahren zur Anwendung.

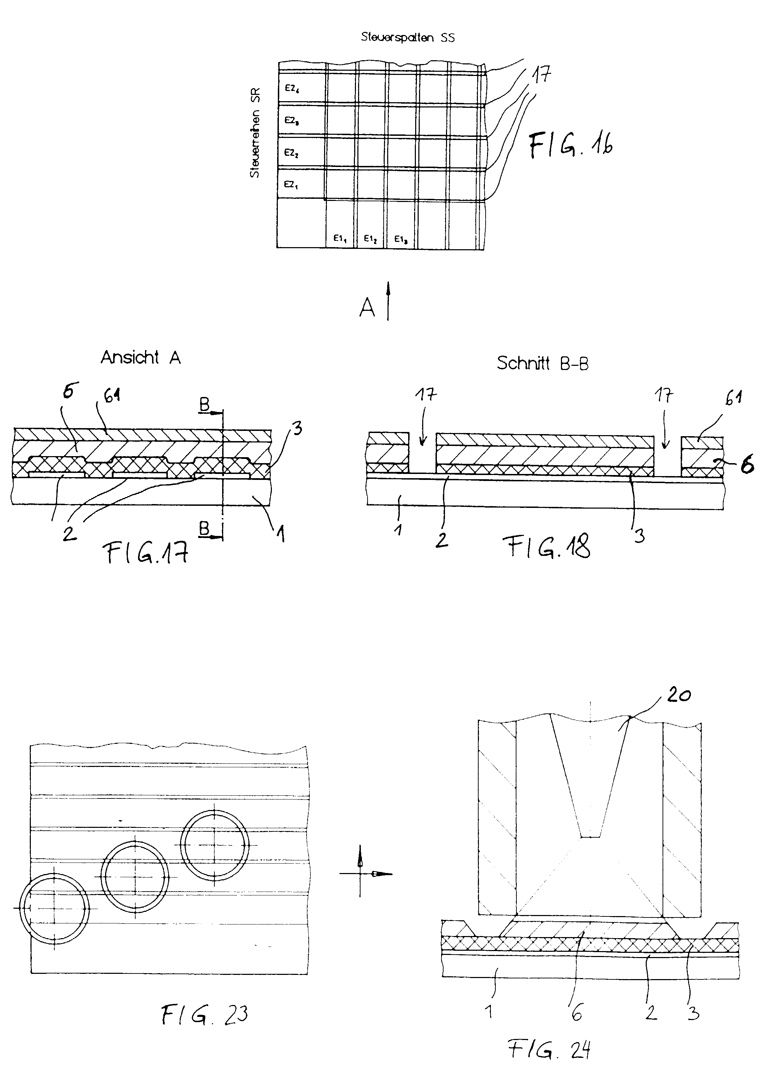

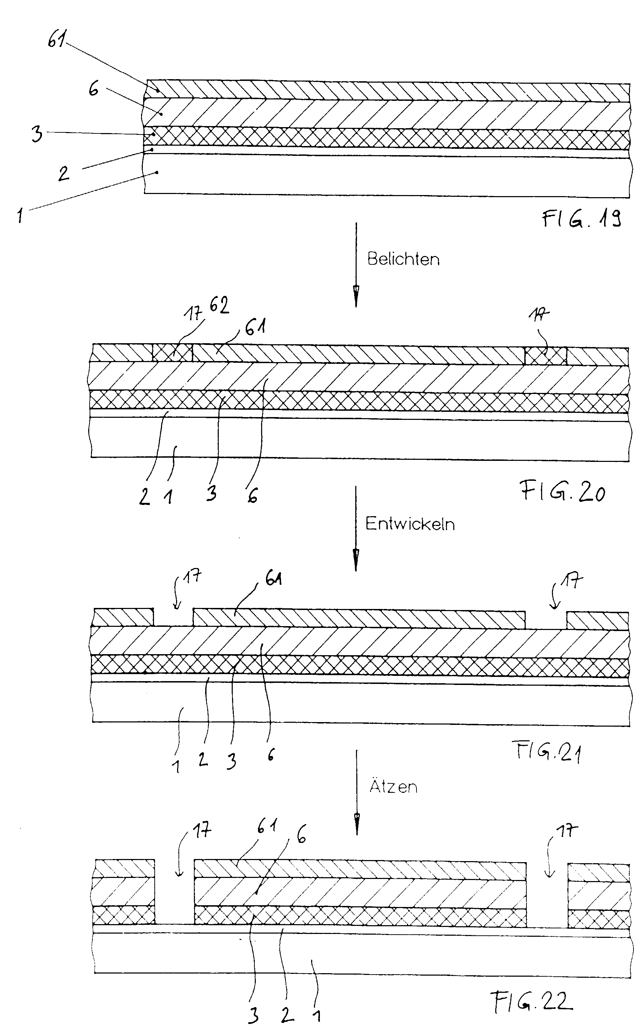

Die Probleme bei den Lithographieverfahren liegen darin, daß die verwendeten Lösungmittel die aktive Schicht beeinflussen können. Um das relativ einfache Verfahren der Photolithographie erfolgreich anwenden zu können, wird gemäß Fig. 19 bis 22 folgendermaßen vorgegangen. Die Deckelektrode 6 wird gemäß Fig. 19 mit einer Photoresist-Lack-Schicht 61 kontinuierlich bedeckt und an den vorgesehenen Stellen 17, die dem Abstand der Steuerreihen 6 entsprechen, etwa mittels einer geeigneten Maske, belichtet (Fig.20). Die belichteten Stellen (Fig.21) der Deckelektrode 6 und das jeweils darunterliegende aktive Elektrolumineszenz-Material 3 werden weggeätzt (Fig.22), dadurch wird auch eine scharfe Trennung zwischen den Bildpunkten einer Steuerspalte 2 erreicht, welche gegen das verwendete Lösungsmittel resistent ist. Der unbelichtete Photoresist-Lack 61 kann auf der Deckelektrode 6 verbleiben, nur an den Randflächen, an der die Kontakte an die Deckelektrodenstreifen 6 angebracht werden, muß er entfernt werden. In diesem Bereich befindet sich aber auch kein aktives Medium, so daß keinerlei Beeinträchtigung des aktiven Materials 3 durch das für das Ätzen verwendete Lösungsmittel auftreten kann.

Eine weitere Möglichkeit für das Strukturieren der Deckelektrode 6 stellt das gezielte Aufdampfen von Deckelektroden 6 aus Düsen 20 gemäß Fig.19 und 20 dar, die über die bereits aufgetragenen Elektrolumineszenzschicht 3 verfahren.

Es können aber auch andere Verfahren zur Herstellung des erfindungsgemäßen Bildschirmes verwendet werden.

Für die Farbwandlerschichten 7 kommen Materialien zur Anwendung, die in einem definierten Wellenlängenbereich absorbieren, in einem geeigneten Wellenlängenbereich emittieren und eine hohe Fluoreszenzquantenausbeute erreichen, z.B. > 90 % in verdünnten Lösungen, wobei Einzelschichten und/oder Sandwichanordnungen aufgebracht werden können.

Zum Aufbringen der, die Primärfarben realisierenden Schichten werden die nachstehend beschriebenen Möglichkeiten eingesetzt.

Die im blauen Spektralbereich absorbierende und im grünen emittierende, fluoreszierende Farbwandlerschicht 7 wird entweder flächig auf die der Elektrodenseite gegenüberliegenden Seite der Grundschicht 1 aufgebracht und anschließend derart strukturiert, daß nur die Bildpunktflächen frei bleiben, die blau leuchten sollen, während die anderen Bildpunktflächen entsprechend mit Farbwandlerschichten 7 versehen sind (Fig.2). Als nächstes wird über die so strukturierte Fläche eine hochtransparente Schutzschicht 9 aufgebracht und zur Herstellung der roten Bildpunkte die im grünen absorbierende und im roten emittierende, fluoreszierende Farbwandlerschicht 7 strukturiert. Mit dem Aufbringen einer Passivierungsschicht 8 wird eine ebene Oberfläche und eine thermische Isolation der Fluoreszenzschichten 7 erreicht. Abschließend werden über jeden lichtemittierenden Bildpunkt den drei Primärfarben angepaßte spektral selektive Spiegel/Transmitterschichten 10 strukturiert, die das austretende Licht spektral reinigen.

Die spektral selektive Spiegel/Transmitter-Schicht 10 kann auch gemäß einer anderen Variante der Erfindung, die in Fig. 27 abgebildet ist, auf die Oberseite einer hochtransparenten Folie 25 strukturiert werden. Dabei wird auf die Grundschicht 1 anstelle der in Fig.25 un d26 gezeigten Anordnung eine Schichtenanordnung bestehend aus den verschiedenen Farbwandlerschichten 7 und der hochtransparenten Schutzschicht 25 aufgebracht.

Es können aber auch Kombinationen aus den beiden vorstehenden beschriebenen Varianten gewählt werden. Die spektral selektive Spiegel/Transmitter-Schicht 10 wird auf der einen Seite der hochtransparenten Folie 25 strukturiert. Auf der anderen Seite wird die im grünen absorbierende und im roten emittierende Fluoreszenzschicht 7 aufgebracht. Eine weitere Möglichkeit besteht darin, auf der Elektrodenseite der Grundschicht 1 die im blauen absorbierende und im grünen emittierende Fluoreszenzschicht 7 herzustellen, während die hochtransparente Schutzschicht 25 optional eingefügt werden kann.

Es gibt aber noch weitere Gestaltungsmöglichkeiten eines erfindungsgemäßen Farbbildschirmes, auf die nachstehend kurz eingegangen wird.

Um das Auflösungsvermögen zu vergrößern, muß der Abstand zwischen dem aktiven Medium 3 und den Fluoreszenzschichten 7 möglichst klein sein. Die Grundschicht 1 wird daher als ein sehr dünnes Substrat ausgeführt oder - ähnlich einer Multichannelplate- aus einzelnen Lichtleitern aufgebaut, um eine gerichtete Emission zu erhalten.

Um die aktive Elektrolumineszenz-Schicht 3 auf eine ebene Fläche homogen aufzudampfen kann jeweils ein Photoresist-Lack 27 zwischen den lichtdurchlässigen Elektroden 2 aufgebracht werden, um den Niveauunterschied zwischen den Elektroden 2 auszugleichen (Fig. 28 und 29).

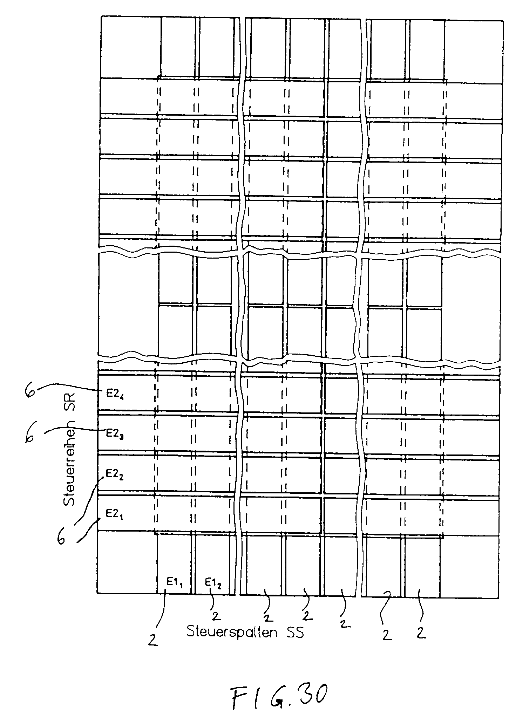

Ein flexibleres Ansteuern der Farbbildpunkte kann durch ein Unterbrechen der Elektroden 2 und 6 erreicht werden. Der Kontaktierungs- und Ansteueraufwand vervielfacht sich allerdings dabei (Fig.30).

Die Grundelektrode 2 wird gemäß dem Ausführungsbeispiel nach Fig.31, 32 und 33 in parallelen Streifen geformt, darüber wird ein elektrisch isolierendes Material 27 in parallelen Streifen orthogonal zu den parallelen Streifen 2 der Grundelektrode aufgebracht. Genau höhenversetzt über die parallelen Streifen 2 der Grundelektrode wird das aktive Elektrolumineszenzmaterial in parallelen diese überlappenden Streifen 3 aufgetragen. Die Deckelektrodenschicht 6 wird nun in parallelen Streifen senkrecht zu den Streifen 3 des aktiven Mediums und höhenversetzt zu den Zwischenräumen der Streifen des isolierenden Materials 27 plaziert.

Ein weiteres Ausführungsbeispiel für die Herstellung eines erfindungsgemäßen Farbbildschirmes ist in den Fig 34, 35 und 36 dargestellt. Die Grundelektrode 2, die nicht eingezeichnete Lochinjektionsschicht 12 und die aktive Elektrolumineszenzschicht 3 werden in parallelen Streifen in Sandwichbauweise auf die Grundschicht 1 aufgebracht. Die nicht eingezeichnete Elektroneninjektionsschicht 13 und die Deckelektrode 6 werden danach flächig aufgedampft und lithographisch in parallelen Streifen orthogonal zu den Streifen der Grundelektrode 2 strukturiert, wobei auch das aktive Medium 3 mitstrukturiert wird und somit in Bildpunktform vorliegt.

In der weiteren Ausführungsform gemäß den Fig.37 bis 39 wird die Grundelektrode 2 in parallelen Streifen geformt, darüber wird eine Schicht isolierendes Material 27 in parallelen Streifen orthogonal zu den parallelen Streifen der Grundelektrode 2 aufgebracht. Über die und höhenversetzt zu den parallelen Streifen der Grundelektrode 2 sowie parallel zu diesen wird das aktive Medium der Elektrolumineszenzschicht 3 in parallelen Streifen geformt. Eine geeignete Elektroneninjektionsschicht 13 wird flächig aufgebracht und in parallelen Streifen 13' belichtet, wodurch sie an diesen Stellen zum Isolator wird. Die Deckelektrodenschicht 6 kann nun problemlos strukturiert werden.

## Patentansprüche

1. Elektrolumineszenzvorrichtung bestehend aus einem Mehrschichtsystem, welches eine unter Einwirkung eines elektrischen Feldes Licht erzeugende aktive Elektrolumineszenzschicht aus einem organischen Halbleiter umfaßt, die zwischen einer Elektronen in die Elektrolumineszenzschicht injizierenden Kathodenschicht und einer Löcher in die Elektrolumineszenzschicht injizierenden Anodenschicht angeordnet ist, wobei gegebenenfalls zwischen der Anodenschicht und der Elektrolumineszenzschicht eine Löcherinjektionsschicht und/oder zwischen der Kathodenschicht und der Elektrolumineszenzschicht eine Elektroneninjektionsschicht angeordnet ist, **dadurch gekennzeichnet**, daß die Elektrolumineszenzschicht (3) langkettiges Oligophenylen in Form einer Verbindung der Formel 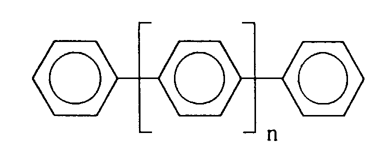 wobei n=2-20, umfaßt.

2. Elektrolumineszenzvorrichtung nach Anspruch 1, **dadurch gekennzeichnet**, daß das Oligophenylen ein fluoriertes Oligophenylen der Formel 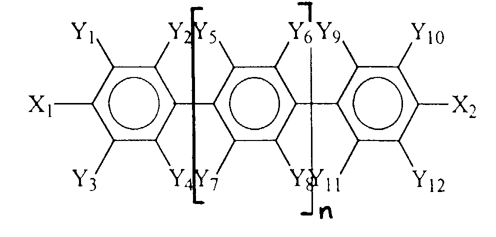 wobei n=2-20 (X₁,X₂, Y_{1...12}:-H, -F, -Alkyl, -Cl, -N, -CF₃, -CN) ist.

3. Elektrolumineszenzvorrichtung bestehend aus einem Mehrschichtsystem, welches eine unter Einwirkung eines elektrischen Feldes Licht erzeugende aktive Elektrolumineszenzschicht aus einem organischen Halbleiter umfaßt, die zwischen einer Elektronen in die Elektrolumineszenzschicht injizierenden Kathodenschicht und einer Löcher in die Elektrolumineszenzschicht injizierenden Anodenschicht angeordnet ist, wobei gegebenenfalls zwischen der Anodenschicht und der Elektrolumineszenzschicht eine Löcherinjektionsschicht und/oder zwischen der Kathodenschicht und der Elektrolumineszenzschicht eine Elektroneninjektionsschicht angeordnet ist, **dadurch gekennzeichnet**, daß die Elektroneninjektionsschicht (13) eine Verbindung der Formel 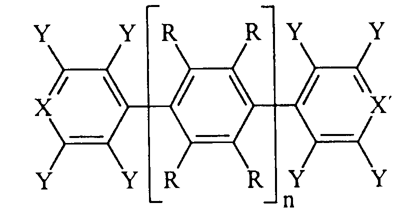 in welcher X, X'= -CCF₃; - CH; -N; -CNH₂; -CCN; -CF; -CBr; und Y, R = H, F; n= 0, 1,...,6; ist, und/oder eine Verbindung der Formel 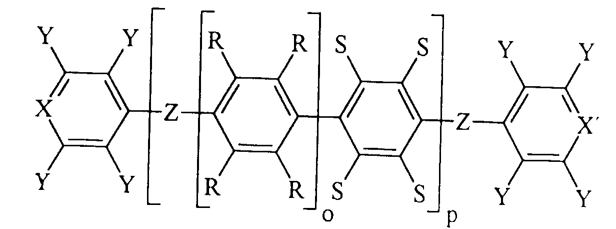 in welcher X, X'= -CCF₃; - CH; -N; -CNH₂; -CCN; -CF; -CBr; Y, R, S = H, F; Z=-CH=CH-, -N=CH-; -naphtalen, -perylen, quarterylen, -porphin, -phtalocyanin: o=0, 1; p= 0, 1, 2; ist. umfaßt.

4. Elektrolumineszenzvorrichtung nach einem der Ansprüche 1 bis 3, **dadurch gekennzeichnet**, daß die Löcherinjektionsschicht (12) Poly- oder Oligoazomethin-ähnliche Verbindungen der Formel 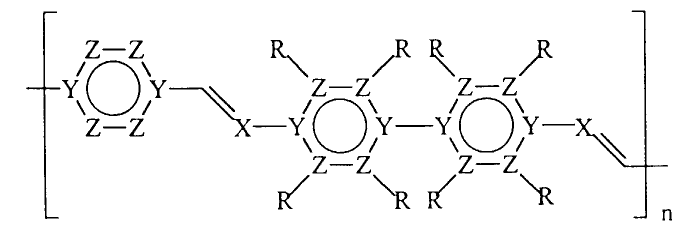 wobei Y, Z= -CCF₃; -CH; -N; -CNH₂; -CCN; -CF; -CBr;R; -H; -alkyl, -CN; X=-CH; -N;-CF, -CCl umfaßt.

5. Elektrolumineszenzvorrichtung nach einem der vorhergehenden Ansprüche, **dadurch gekennzeichnet**, daß jeweils zwischen der Anoden- oder Kathodenschicht (2, 6) und der Elektrolumineszenzschicht (3) bzw. der Elektronen- oder Löchertransportschicht (13, 12) eine aus silanisierten Verbindungen, z.B. ClSi, gebildete Schicht angeordnet ist.

6. Elektrolumineszenz-Farbbildschirm mit Matrix-Bildpunkten bestehend aus einem Mehrschichtsystem von übereinander und teilweise nebeneinander aufgetragenen Einzelschichten, welches eine isolierende, optisch zumindest transluzente Grundschicht, eine leitfähige, optisch zumindest transluzente, streifenförmig strukturierte Grundelektrodenschicht, eine organische Elektrolumineszenzvorrichtung, insbesondere nach einem der Ansprüche 1 bis 5, eine streifenförmig strukturierte Deckelektrodenschicht, gegebenenfalls eine oder mehrere matrixartig aufgetragene Farbwandlerschichten und eine oder mehrere Passivierungsschichten umfaßt, **dadurch gekennzeichnet**, daß - in Emissionsrichtung des Lichtes gesehen - jeweils nach der Grundschicht oder nach der oder den Farbwandlerschicht(en) (7) eine oder mehrere spektral selektive Spiegel/Transmitter-Schichten (10) zur spektralen Reinigung und Effizienzsteigerung des Emissionsspektrums angeordnet ist bzw. sind.

7. Elektrolumineszenz-Farbbildschirm nach Anspruch 6, **dadurch gekennzeichnet**, daß die spektral selektiven Spiegel/Transmitter-Schichten (10) aus Schichten mit abwechselnd hohem und niedrigem optischen Brechungsindex gebildet sind, wobei vorzugsweise die Schicht mit hohem optischen Brechungsindex jeweils aus TiO₂ und die Schicht mit niedrigem Brechungsindex jeweils aus MgF₂ gebildet ist.

8. Farbbildschirm nach Anspruch 6 oder 7, **dadurch gekennzeichnet**, daß - in Emissionsrichtung des Lichtes - nach der Grundschicht (1) und/oder den Farbwandlerschichten (1) eine hochtransparente Schutzschicht (7) angeordnet ist.

9. Farbbildschirm nach Anspruch 6, 7 oder 8, **dadurch gekennzeichnet**, daß eine oder mehrere Isolierschichten (8) zwischen den Farbwandlerschichten vorgesehen sind.

10. Farbbildschirm nach einem der Ansprüche 6 bis 9, **dadurch gekennzeichnet**, daß die Grundschicht aus einzelnen in Emissionsrichtung des Lichtes angeordneten Lichtleitern gebildet ist.

11. Farbbildschirm nach einem der Ansprüche 6 bis 10, **dadurch gekennzeichnet**, daß die streifenförmige Grundelektroden- und die Deckelektrodenschicht (2, 6) jeweils einmal unterbrochen sind.

12. Farbbildschirm nach einem der Ansprüche 6 bis 11, **dadurch gekennzeichnet**, daß die aus fluoreszierenden Farbstoffen gebildeten Farbwandlerschichten chemisch als Seitenketten an ein Trägerpolymer gebunden sind.

13. Farbbildschirm nach einem der Ansprüche 6 bis 12, **dadurch gekennzeichnet**, daß die Moleküle der fluoreszierenden Farbstoffe der Farbwandlerschichten matrixartig und voneinander isoliert eingebaut sind, wobei die Matrix z.B. durch PMMA, Polystyrol gebildet ist.

14. Farbbildschirm nach einem der Ansprüche 6 bis 13, **dadurch gekennzeichnet**, daß die Farbwanderschicht(en) eine vorbestimmbare Orientierungsrichtung der Farbstoffmoleküle aufweisen.

15. Farbbildschirm nach einem der Ansprüche 6 bis 14, **dadurch gekennzeichnet**, daß die Deckelektrodenschicht aus zwei oder mehreren Stoffen gebildet ist.

16. Farbbildschirm nach einem der Ansprüche 6 bis 15, **dadurch gekennzeichnet**, daß eine optisch polarisierende Farbwandlerschicht vorgesehen ist.

17. Farbbildschirm nach einem der Ansprüche 6 bis 16, **dadurch gekennzeichnet**, daß zwei unterschiedliche Elektrolumineszensschichten mit jeweils einer Grundfarbe matrixartig angeordnet sind, und daß nach jeweils einer von drei Matrixpunkten Farbwandlerschicht angeordnet ist.

18. Verfahren zur Herstellung eines Farbbildschirmes nach einem der Ansprüche 1 bis 17, **dadurch gekennzeichnet**, daß die Grundelektrodenschicht (2) in parallelen Streifen auf die Grundschicht (1) aufgetragen wird, daß darüber ein elektrisch isolierendes Material (27) in parallelen Streifen orthogonal zu den parallelen Streifen (2) der Grundelektrodenschicht aufgebracht wird, daß darauffolgend über und höhenversetzt zu den parallelen Streifen (2) der Grundelektrodenschicht das aktive Elektrolumineszenzmaterial in parallelen Streifen (3) aufgetragen wird, daß die Deckelektrodenschicht (6) darauffolgend in parallelen Streifen senkrecht zu den Streifen (3) der Elektrolumineszenzschicht und höhenversetzt über den Zwischenräumen der parallelen Streifen (27) des elektrisch isolierenden Materials aufgebracht wird.

19. Verfahren nach Anspruch 18, **dadurch gekennzeichnet**, daß auf die aktive Elektrolumineszenzschicht (3) eine lichtempfindliche Elektroneninjektionsschicht (13) flächig aufgebracht und in parallelen Streifen (13') belichtet wird, wodurch sie an diesen Stellen zum Isolator wird, und daß darauffolgend die Deckelektrodenschicht (6) streifenförmig strukturiert wird.

20. Verfahren zur Herstellung eines Farbbildschirmes nach einem der Ansprüche 1 bis 19, **dadurch gekennzeichnet**, daß die Grundelektrodenschicht (2), die Lochinjektionsschicht (12) und die aktive Elektrolumineszenzschicht (3) in übereinanderliegenden parallelen Streifen auf die Grundschicht (1) aufgebracht werden, daß die Elektroneninjektionsschicht (13) und die Deckelektrodenschicht (6) darauffolgend flächig aufgebracht, vorzugsweise aufgedampft, und dann in parallelen Streifen orthogonal zu den Streifen der Grundelektrode (1) streifenförmig strukturiert werden, wobei die aktive Elektrolumineszenzschicht (3) mitstrukturiert wird.

21. Vorrichtung zur Erzeugung von weißem, polarisiertem Licht mit einer blaues Licht erzeugenden Elektrolumineszenzvorrichtung, insbesonders einer organischen Elektrolumineszenzvorrichtung nach einem der Ansprüche 1 bis 6, **dadurch gekennzeichnet**, daß - in Emissionsrichtung des Lichtes gesehen - orientierte Farbwandlerschichten angeordnet sind, in denen Farbstoffe mit einer optischen Vorzugsrichtung enthalten sind, die vorzugsweise in einer Flüssigkristall-Matrix ausrichtbar sind.

22. Vorrichtung nach Anspruch 21, **dadurch gekennzeichnet**, daß der Farbstoff der Farbwandlerschicht einfallendes Licht nur jeweils senkrecht zu seiner Molekülachse absorbiert und das farbgewandelte Licht in Richtung seiner Molekülachse emittiert.

23. Vorrichtung nach Anspruch 21 oder 22, **dadurch gekennzeichnet**, daß - in Emissionsrichtung des Lichtes gesehen - ein oder mehrere spektral selektive Spiegel/Transmitterschichten angeordnet sind.

24. Vorrichtung nach Anspruch 21, 22 oder 23, **dadurch gekennzeichnet**, daß das emittierte blaue Licht der Elektrolumineszenzvorrichtung polarisiert ist, und daß die Dichte der Farbwandlerschicht oder -schichten so gewählt ist, daß ein Teil des emittierten blauen Lichtes die Farbwandlerschichten ohne Farbumwandlung durchdringt.
